Europäisches Patentamt

European Patent Office

Office européen des brevets

(19)

(11) Publication number : **0 333 326 B1**

(12) # EUROPEAN PATENT SPECIFICATION

(45) Date of publication of patent specification :
20.12.95 Bulletin 95/51

(51) Int. Cl.⁶ : **G03B 41/00**, G03F 9/00,
G03B 27/53

(21) Application number : **89301471.2**

(22) Date of filing : **16.02.89**

(54) **Position detecting method and apparatus**

(30) Priority : **16.02.88 JP 33203/88
29.12.88 JP 334733/88**

(43) Date of publication of application :
**20.09.89 Bulletin 89/38**

(45) Publication of the grant of the patent :
**20.12.95 Bulletin 95/51**

(84) Designated Contracting States :
**DE FR GB NL**

(56) References cited :
**US-A- 4 037 969
US-A- 4 360 273
US-A- 4 631 416
JAPANESE JOURNAL OF APPLIED PHYSICS,
no. 6, part II, June 1986, pp. L487-L489, Tokyo,
Japan ; J. ITOH et al. : "A new interferometric
displacement-detection method for mask-
to-wafer alignment using symmetrically-
arranged three gratings".
PATENT ABSTRACTS OF JAPAN, vol. 10, no.
294 (P-504)(2350), 7th October 1986 ; & JP-A-61
111 402**

(73) Proprietor : **CANON KABUSHIKI KAISHA
30-2, 3-chome, Shimomaruko,
Ohta-ku
Tokyo (JP)**

(72) Inventor : **Saitoh, Kenji
1-30-40-132 Higashiterao Tsurumi-ku
Yokohama-shi Kanagawa-ken (JP)**
Inventor : **Matsugu, Masakazu
Canon-ryo
2-6-29 Mizuhiki
Atsugi-shi Kanagawa-ken (JP)**
Inventor : **Niwa, Yukichi
2-3-3-501 Akitsu
Narashino-shi Chiba-ken (JP)**
Inventor : **Nose, Noriyuki
Tadao-Sentoralu Manshon
1-28-8-203 Tadao
Michida-shi Tokyo (JP)**
Inventor : **Yoshii, Minoru
1-14-24 Higashinakano
Nakano-ku Tokyo (JP)**
Inventor : **Suda, Shigeyuki
1-30-40-333 Higashiterao
Tsurumi-ku
Yokohama-shi Kanagawa-ken (JP)**

(74) Representative : **Beresford, Keith Denis Lewis
et al
BERESFORD & Co.
2-5 Warwick Court
High Holborn
London WC1R 5DJ (GB)**

## Description

FIELD OF THE INVENTION AND RELATED ART

This invention relates generally to an alignment system for correctly positioning an object. More particularly, the invention is concerned with position detecting method and apparatus suitably usable in a semiconductor microcircuit device manufacturing exposure apparatus for lithographically transferring a fine electronic circuit pattern formed on the surface of a first object (original) such as a mask or reticle (hereinafter simply "mask") onto the surface of a second object (workpiece) such as a wafer, for relatively positioning or aligning the mask and the wafer.

In exposure apparatuses for use in the manufacture of semiconductor devices, the relative alignment of a mask and a wafer is one important factor in respect to ensuring improved performance. Particularly, as for alignment systems employed in recent exposure apparatuses, submicron alignment accuracies or more strict accuracies are required in consideration of the demand for higher degree of integration of semiconductor devices.

In many types of alignment systems, features called "alignment patterns" are provided on a mask and a wafer and, by utilizing positional information obtainable from these patterns, the mask and wafer are aligned. As for the manner of executing the alignment, as an example there is a method wherein the amount of relative deviation of these alignment patterns is detected on the basis of image processing. Another method is proposed in U.S. Patent No. 4,037,969 and Japanese Laid-Open Patent Application, Laid-Open No. Sho 56-157033, wherein so-called zone plates are used as alignment patterns upon which light is projected and wherein the positions of light spots formed on a predetermined plane by lights from the illuminated zone plates are detected.

Other alignment systems are proposed in US-A-4631416, US-A- 4360273 and in "A new interferometric displacement-detection method ..." by J.Itoh et al., published in Japanese Journal of Applied Physics Vol.25, No.6, June 1986, pages L487-L489.

Generally, an alignment method utilizing a zone plate is relatively insensitive to any defect of an alignment pattern and therefore assures relatively high alignment accuracies, as compared with an alignment method simply using a traditional alignment pattern.

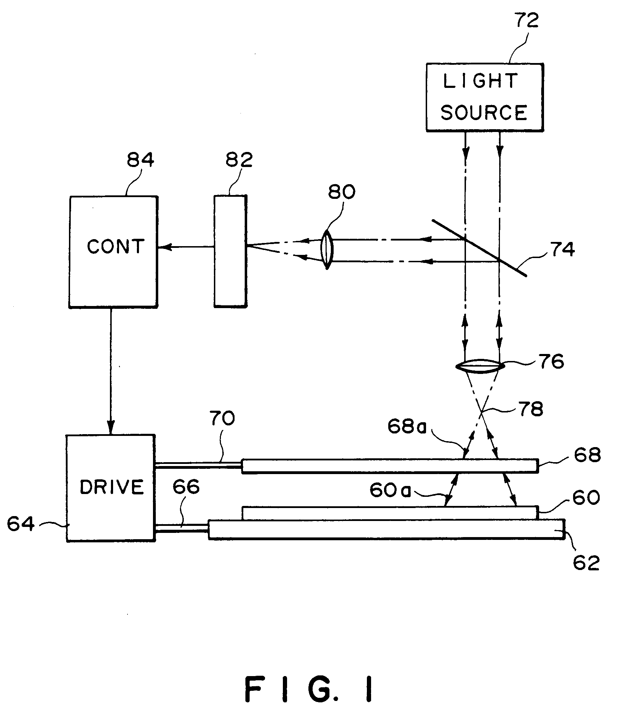

Figure 1 is a schematic view of a known type alignment system utilizing zone plates.

In Figure 1, a parallel light emanating from a light source 72 passes through a half mirror 74 and is focused at a point 78 by a condensing lens 76. Thereafter, the light illuminates a mask alignment pattern 68a on a mask 68 and an alignment pattern 60a on a wafer 60 which is placed on a support table 62. Each of these alignment patterns 68a and 60a is provided by a reflection type zone plate and functions to form a spot of focused light on a plane perpendicular to an optical axis which contains the point 78. The amount of relative deviation of the positions of these light spots formed on that plane is detected, by directing the focused beams to a detection plane 82 by means of the condensing lens 76 and another lens 80.

In accordance with an output signal from the detector 82, a control circuit 84 actuates a driving circuit 64 to relatively align the mask 68 and the wafer 60.

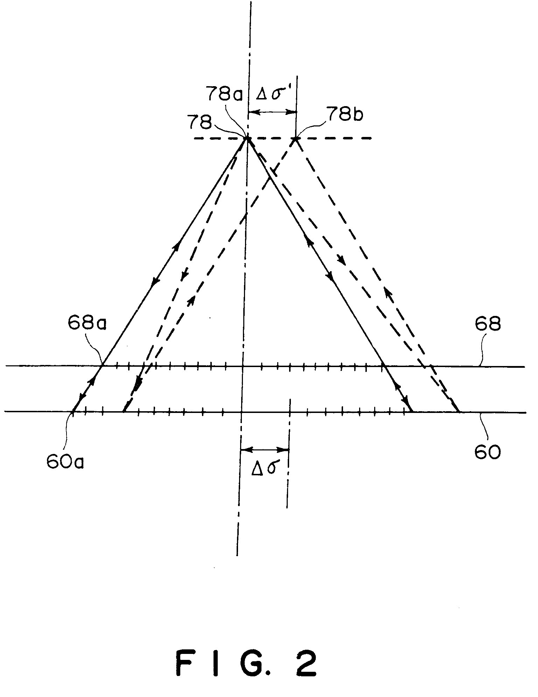

Figure 2 illustrates an imaging relationship of lights from the mask alignment pattern 68a and the wafer alignment pattern 60a shown in Figure 1.

In Figure 2, a portion of the light divergently advancing from the point 78 is reflectively diffracted by the mask alignment pattern 68a and forms a spot 78a of focused light at or adjacent to the point 78, the spot representing the mask position. Another portion of the light passes through the mask 68 in the form of a zero-th order transmission light and is projected upon the wafer alignment pattern 60a on the wafer 60 surface with its wavefront being unchanged. The incident light is reflectively diffracted by the wafer alignment pattern 60a and then passes again through the mask 68 in the form of a zero-th order transmission light, and finally is focused in the neighborhood of the point 78 to form a spot 78b of focused light, representing the wafer position. In the illustrated example, when the light diffracted by the wafer 60 forms a spot, the mask 68 functions merely as a transparent member.

The position of the spot 78b formed by the wafer alignment pattern 60a in the described manner represents a deviation $\Delta\sigma'$, in the plane perpendicular to the optical axis containing the point 78, of an amount corresponding to the amount of deviation $\Delta\sigma$ of the wafer 60 with respect to the mask 68.

When in the illustrated alignment system the amount of relative positional deviation is to be determined, the lights from the zone plates provided on the mask and the wafer are independently imaged upon a predetermined plane at which the evaluation should be made, and the amount of deviation of each imaged light from a corresponding reference position is detected.

In this case, to simply evaluate direct images from the zone plates is not preferable because the displacement in the predetermined plane corresponding to the relative positional deviation is approximately of the same amount and is small. Therefore, in order to assure high-precision alignment, there is a necessity of using an enlarging system, for example, for enlarging the displacement in the predetermined plane.

If, however, such an enlarging system is provided, there arise some problems, an example of which is that the assembling precision of that system or any variation in the alignment process affects the accuracy, resulting in the difficulty in detecting with high precision the amount of deviation of the light spot in the predetermined plane.

According to the present invention a method of detecting the relative positional deviation between first and second objects in a predetermined direction perpendicular to the direction in which the first and second objects are opposed to each other, comprising the steps of: providing the first object with a first optical element for converging or diverging an incident radiation beam; providing the second object with a second optical element for converging or diverging an incident radiation beam, said first and second optical elements being effective together to provide positive magnification; projecting a radiation beam onto said first optical element in such a manner that the radiation beam converged or diverged by said first optical element impinges on said second optical element and is converged onto a photoelectric sensor, whereupon any relative positional deviation between the first and second objects causes deflection of the beam; detecting the position of incidence of said radiation beam on said photoelectric sensor; and processing an electric signal from the sensor with respect to a reference signal to detect the relative positional deviation between the first and second objects in the predetermined direction.

According to the present invention an exposure system for projecting a pattern on a mask on to a wafer by a radiation beam from a radiation source in order to transfer the pattern of the mask on to the wafer, comprising means to align the mask and the wafer in accordance with a detected positional deviation between them, and further comprising:

a) a first optical element provided on the mask for converging or diverging an incident radiation beam from the radiation source;

b) a second optical element provided on the wafer for converging or diverging an incident radiation beam from the first optical element, said first and second optical elements being effective together to provide positive magnification; whereupon any relative positional deviation between the mask and the wafer causes deflection of the beam;

c) a photoelectric sensor to detect thereon the position of incidence of the radiation beam from the second optical element; and

d) a signal processor connected to the sensor to process an electric signal indicative of the relative positional deviation between the mask and the wafer in a direction normal to the direction in which the mask and the wafer are opposed to one another, in relation to a reference signal to determine the deviation.

According to the present invention a semiconductor device manufacturing method in which a pattern on a mask is projected on to a wafer by a radiation beam from a radiation source in order to transfer the pattern of the mask on to the wafer, means being provided to align the mask and the wafer in accordance with a detected deviation between them, comprising the steps of:

a) providing the mask with a first optical element for converging or diverging an incident radiation beam from the radiation source;

b) providing the wafer with a second optical element for converging or diverging an incident radiation beam from the first optical element, said first and second optical elements being effective together to provide positive magnification;

c) providing a photoelectric sensor to detect the radiation beam from the second optical element; and

d) providing a signal processor connected to the sensor to process an electrical signal indicative of the relative positional deviation between the mask and the wafer in a direction normal to the direction in which the mask and the wafer are opposed to one another, with respect to a reference signal, to determine the deviation.

How the invention may be carried out will now be described by way of example only and with reference to the accompanying drawings in which:

## BRIEF DESCRIPTION OF THE DRAWINGS

Figures 1 and 2 are schematic views for explicating a known type alignment system using zone plates.

Figure 3 is a principle view for explicating the principle of position detection used in the present invention.

Figure 4 illustrates the action of an optical arrangement of the Figure 3 example.

Figure 5 is a graph showing the relationship between a relative positional deviation and a corresponding shift of center of gravity of light, in the optical system shown in Figure 3.

EP 0 333 326 B1

Figures 6A and 6B are graphs for explicating the concept of detecting relative positional deviation, on the basis of shift of the center of gravity of light.

Figures 7A and 7B illustrate the optical action of physical optic elements.

Figures 8A.1 and 8B.1 each exemplifies a pattern of a zone plate.

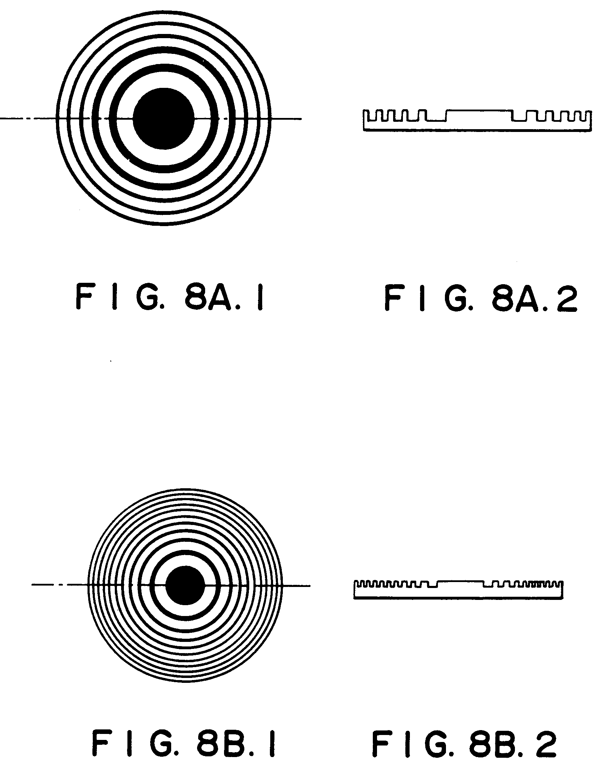

Figures 8A.2 and 8B.2 each is a section illustrating a phase type zone plate.

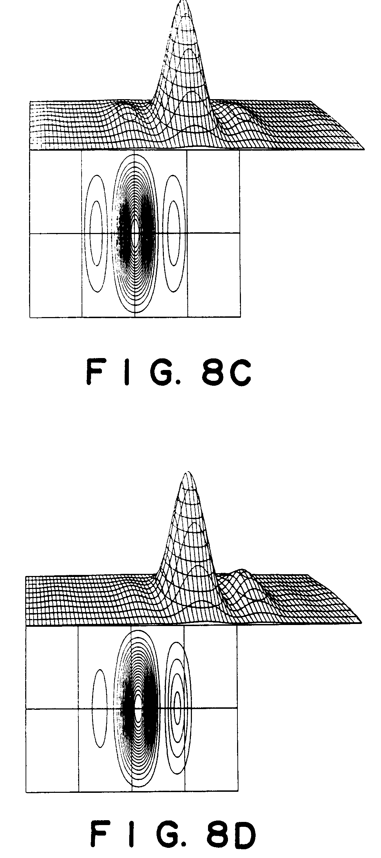

Figures 8C and 8D each illustrates a light intensity distribution on a detecting surface.

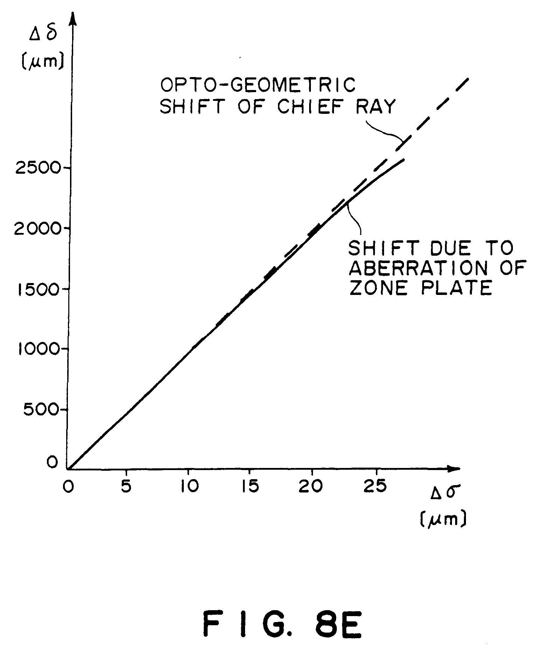

Figure 8E is a graph which exemplifies the relationship between the relative positional deviation and the shift of center of gravity of light.

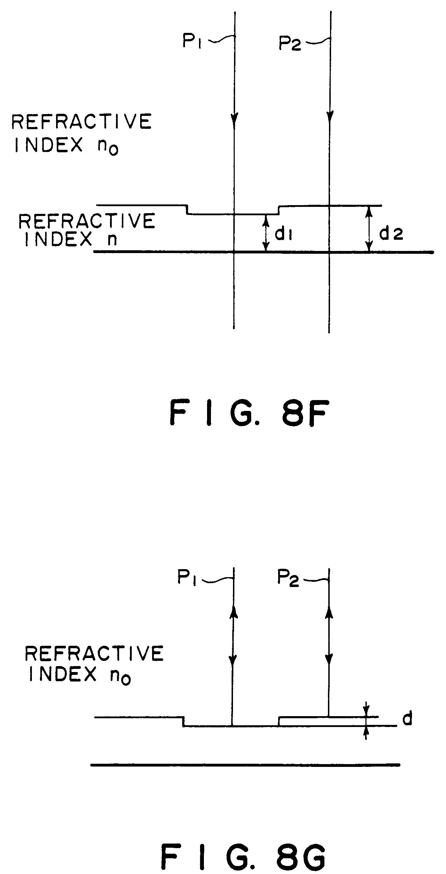

Figures 8F and 8G are principle views explicating a transmission type phase grating and a reflection type phase grating.

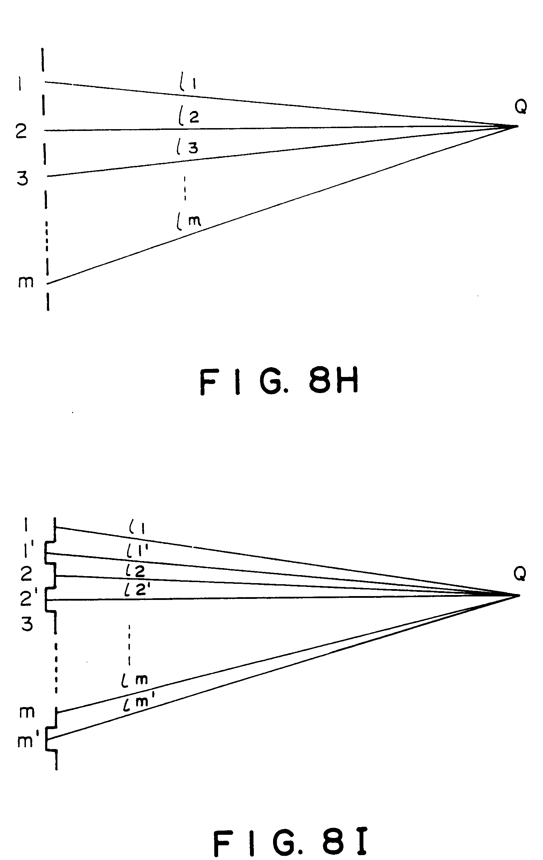

Figures 8H and 8I are principle views for explicating an amplitude type grating and a phase type grating, respectively.

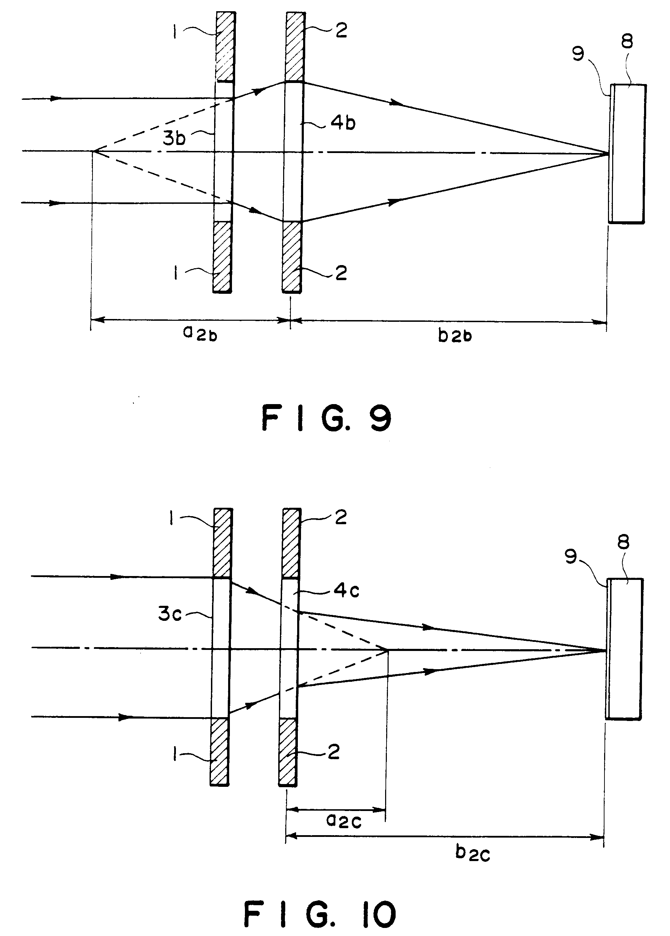

Figure 9 is a schematic view showing a major portion of a position detecting device according to an embodiment of the present invention.

Figure 10 is similar to Figure 9 but shows another embodiment of the present invention.

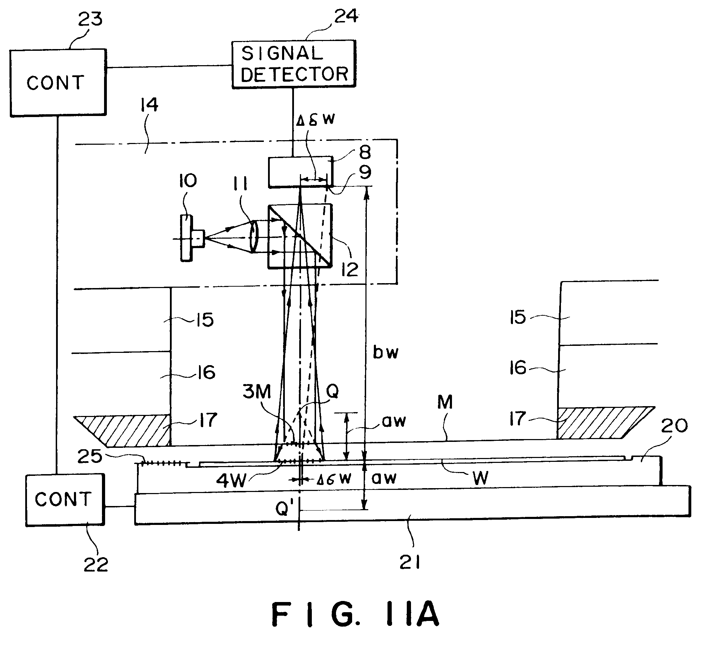

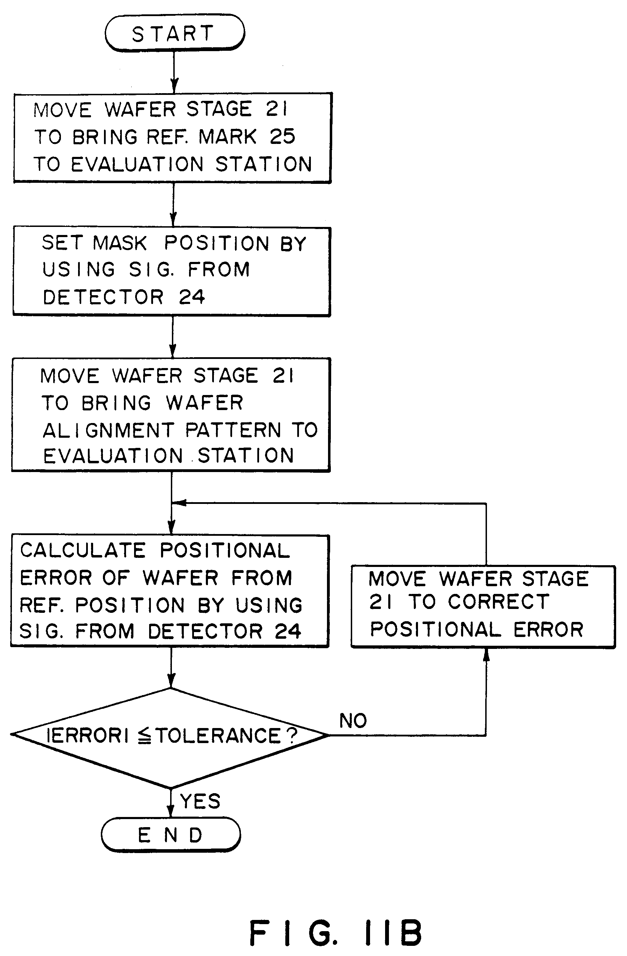

Figure 11A is a schematic view showing a major portion of an exposure apparatus according to an embodiment of the present invention.

Figure 11B is a flow chart showing the sequence of alignment operation to be made in the apparatus of Figure 11A.

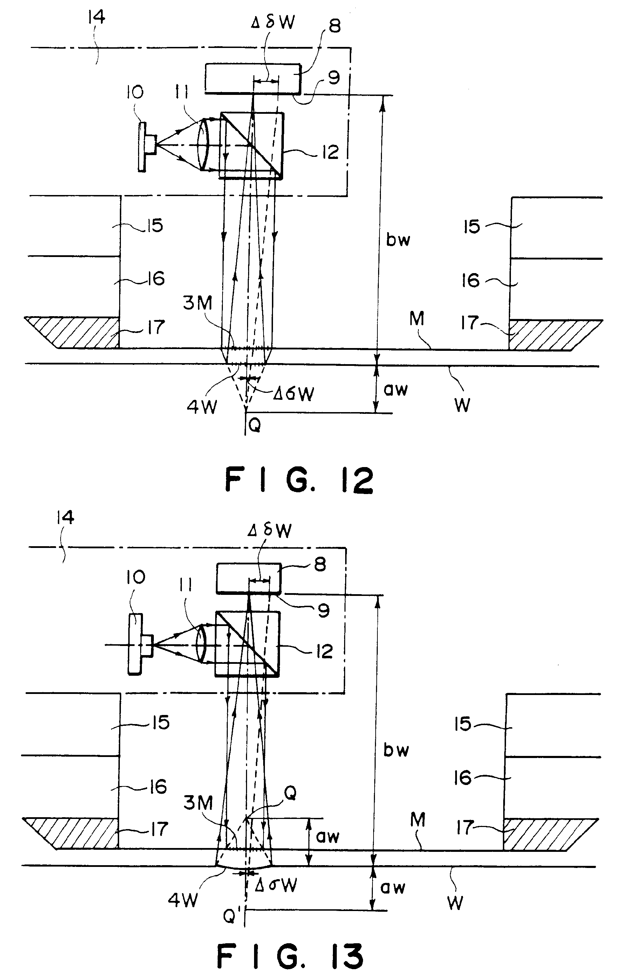

Figures 12 - 16 are schematic views each showing a major portion of an exposure apparatus according to an embodiment of the present invention.

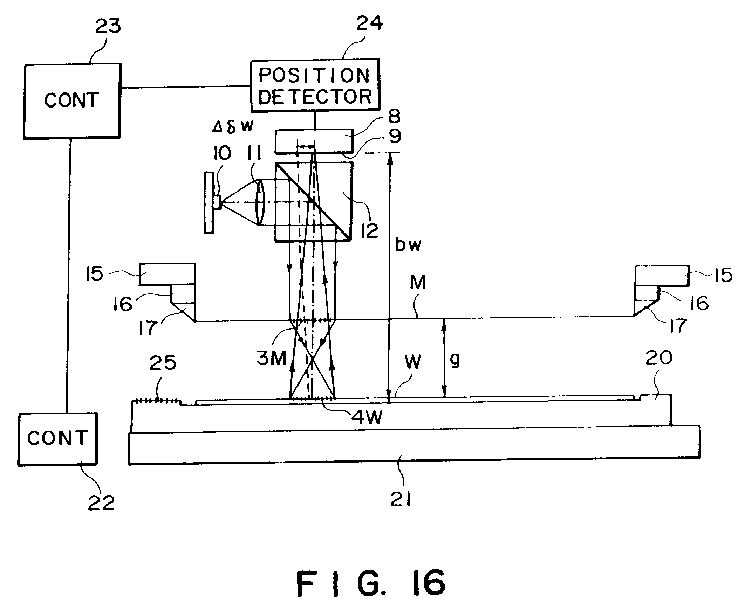

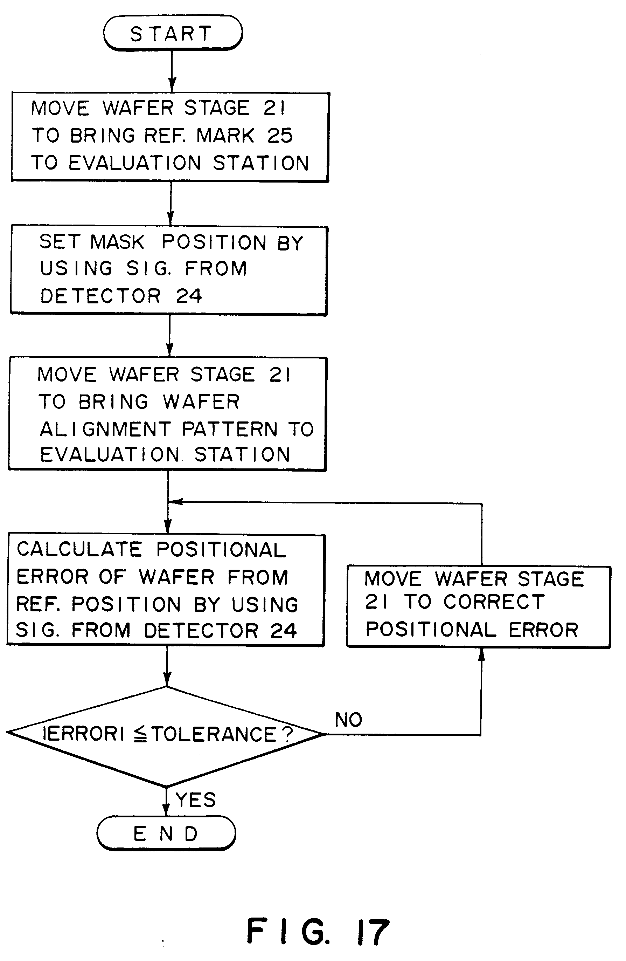

Figure 17 is a flow chart showing the sequence of alignment operation to be made in the exposure apparatus of Figure 16.

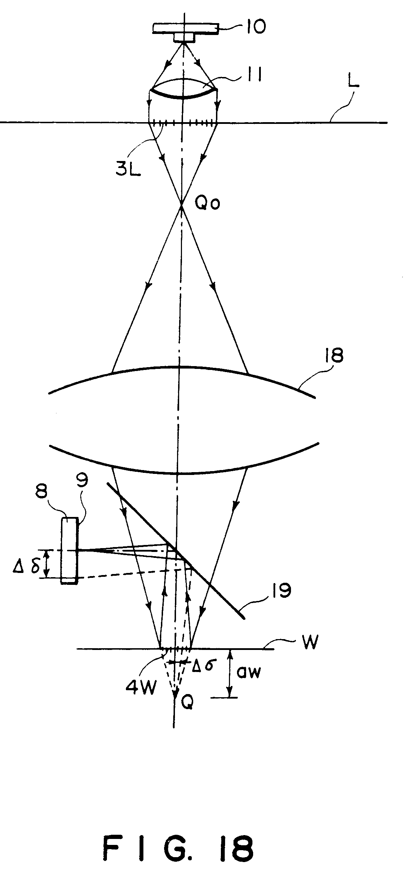

Figures 18 - 22 are schematic views each showing a major portion of an exposure apparatus according to an embodiment of the present invention.

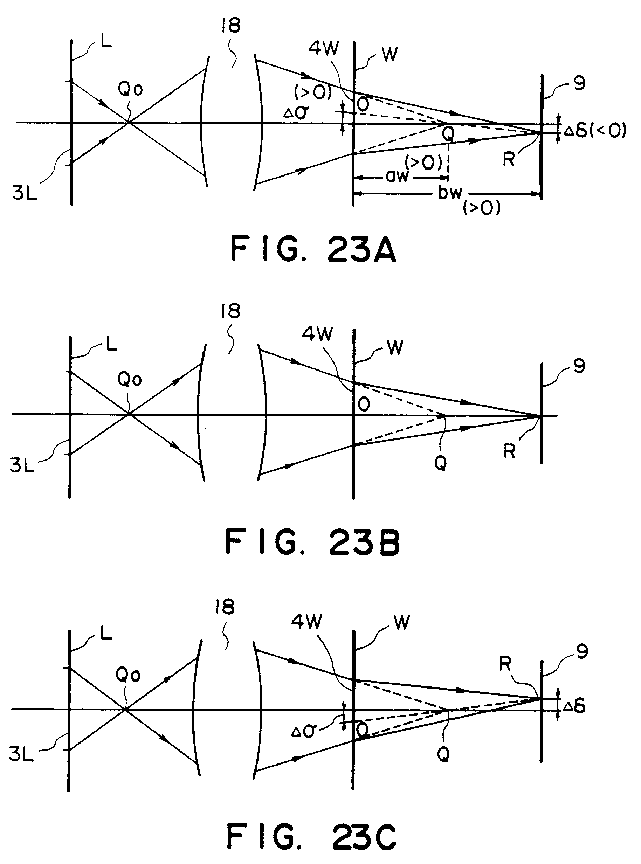

Figures 23A - 23C, Figures 24A - 24C, Figures 25A - 25C and Figures 26A - 26C, are principle views, respectively, for explicating the principle of alignment in some examples in which the invention is applied to a projection type exposure apparatus and in which the used alignment patterns have different powers.

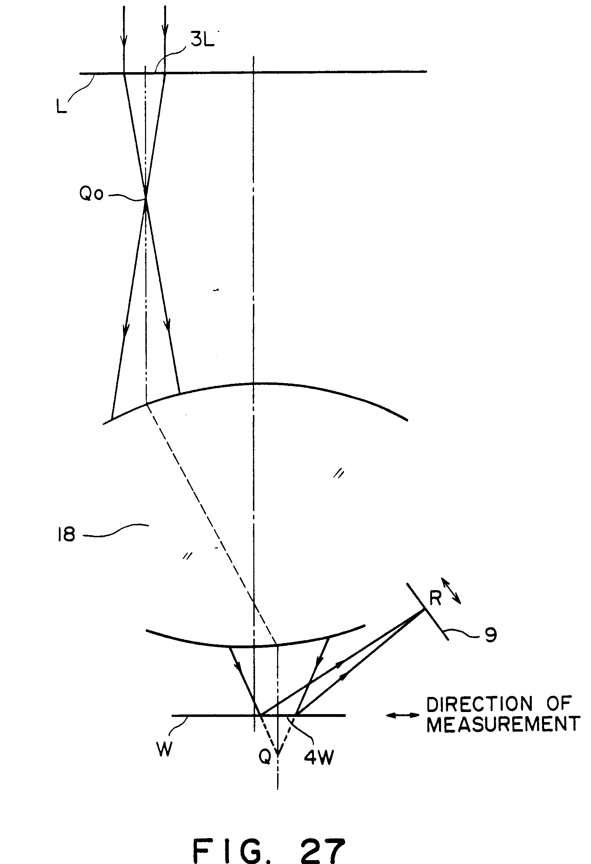

Figures 27 - 34 are schematic representations each illustrating a major portion of a lens projection type exposure apparatus according to a different embodiment of the present invention.

DESCRIPTION OF THE PREFERRED EMBODIMENTS

Where Fresnel zone plates are provided on two relatively movable objects and when they are placed one upon another and a collimated light such as a collimated laser beam is projected thereupon, the light is converged by these two Fresnel zone plates so that plural light spots are formed. The interval of these light spots is the function of the distance or deviation S of the centers of the two Fresnel zone plates. This is discussed in "Applied Optics", August 1969, Vol. 8, No. 8, 1707 - 1712, by Henry H. M. Chau; and in "Journal of the Optics Society of America", February 1970, Vol. 6, 255 - 259, by Henry H. M. Chau. Briefly, the present invention utilizes the phenomenon that the displacement of light that forms one spot corresponds to the change in the deviation of the centers of two Fresnel zone plates, and, by detecting such a light, the relative position of two objects is detected. Particularly, in an occasion where the two objects are a mask and a wafer which are used in a proximity type exposure apparatus wherein the mask and the wafer are placed in close proximity to each other and, by using a suitable radiation energy, a pattern formed on the mask is transferred onto the wafer, two different physical optic elements such as Fresnel zone plates having different lens functions such as a concave-lens function and a convex-lens function are provided on the mask and the wafer, and the light having been influenced by the different lens functions of the two physical optic elements is detected. On the basis of this detection, the relative position of the mask and the wafer can be detected with high precision and high resolution.

The point of convergence or the origin of divergence of light converged or diverged by one of two physical optic elements provided on a mask and a wafer, respectively, displaces only by substantially the same amount of the displacement of one physical optic element. When the thus converged or diverged light is converged or diverged by the other physical optic element and if this is done so that the distance between the other physical optic element and the point of convergence of the light emanating from the same physical optic element becomes greater than the distance between the said other physical optic element and the point of convergence or the origin of divergence of the light which is going to enter the said other physical optic element, then the point of convergence of the light emanating from the said other physical optic element displaces of an amount several times larger than the amount of relative displacement of the mask and the wafer. Therefore, by detect-

4

EP 0 333 326 B1

ing, for example, the position of the point of convergence of the light forming the spot, it is possible to detect the amount of relative displacement of the mask and the wafer, at a certain enlarging magnification. As a result, the position detection can be made with significantly higher precision and higher resolution.

In an occasion where both of the two physical optic elements have a function of a convex lens, and in order to once focus the light at a location between the two physical optic elements so as to satisfy the above-described condition, it is necessary that each lens has a large power. In a proximity exposure apparatus wherein a mask and a wafer are placed with an interspacing of an order of 10 microns to 1 millimeters, the fabrication of a physical optic element having such a large power may not be so easy. Further, where both of the two physical optic elements have a function of a convex lens or a concave lens, it may be necessary to use a divergent or convergent light in order to satisfy the above-described condition in regard to the distance of the point of convergence. This, however, is not convenient because in that case it is necessary to retain, with high precision, the position of the point of convergence or the origin of divergence of the light to be projected upon the first physical optic element. Therefore, there is a possibility of deteriorated detection accuracies, as compared with that as attainable in a case where a parallel light is projected. In consideration of the above, preferably one of two physical optic elements may have a function of a convex lens while the other may have a function of a concave lens. In that case, advantageously, a parallel light can be used and, in addition thereto, the fabrication of physical optic elements for use in a proximity exposure apparatus is facilitated.

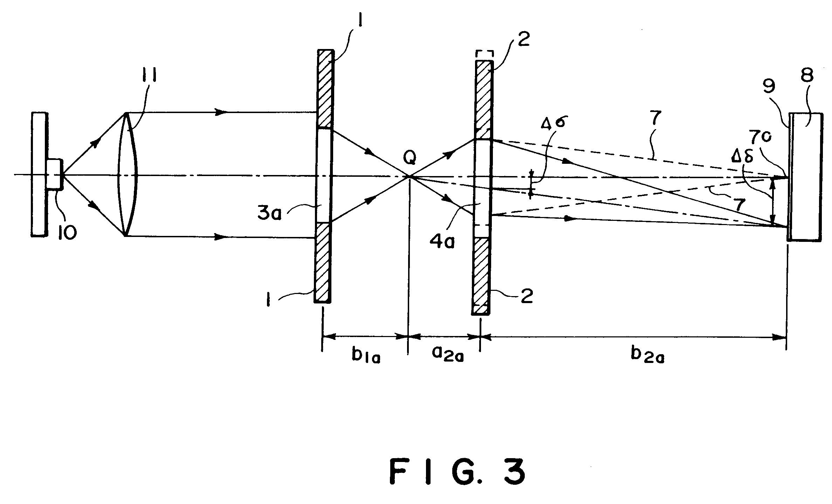

For better understanding of the present invention, reference will now be made to Figure 3. In this illustration, a light emitted from a light source 10 is collimated into a parallel light by means of a lens 11, and the parallel light illuminates a first physical optic element 3a which is provided on a first object 1 and which is formed by a zone plate, for example.

The first physical optic element 3a has a light converging function to focus the light, emanating therefrom, at a point Q which is at a distance $b_{1a}$ from the first physical optic element 3a. The light divergingly advancing from the point Q impinges on a second physical optic element 4a which is provided on a second object 2 disposed at a distance $a_{2a}$. Similarly, the second physical optic element 4a is formed by a zone plate, for example. Also, similarly to the first physical optic element 3a, the second physical optic element 4a has a light-converging function and focuses the light, emanating therefrom, upon a light detection surface 9 of a detector (sensor) 8. Namely, in the illustrated example, the first and second physical optic elements 3a and 4a provide what can be called a "convex-convex system".

In a method of detecting relative positional deviation of first and second objects 1 and 2, according to one or more embodiments of the present invention which will be described later, a point image (real image or virtual image) as formed by a first physical optic element 3a is projected upon a sensor 8 by a second physical optic element 4a so as to satisfy that the absolute value of an imaging magnification $\beta2$ as can be defined by "$b_{2a}/a_{2a}$" is large. By doing so, any positional deviation of the second physical optic element can be detected as a displacement of the point image upon the sensor 8, of an amount significantly larger than the amount of the positional deviation of the second physical optic element. Therefore, the resolution of the detection can be improved.

Usually, by increasing an effective diameter W of the second physical optic element 4a, the size of the point image (spot) on the sensor 8 can be reduced with a result of increased detection resolution. In semiconductor device manufacturing apparatuses, however, for higher degree of integration of semiconductor devices, it is desired to reduce the size of a region to be occupied by an alignment mark. In consideration of this, it is not desirable to prepare a so wide region to be occupied by a mark.

On the other hand, for ensuring the diffraction effect, a physical optic element may have a minimum line width preferably not smaller than the wavelength $\lambda$ of light used for detection of the positional deviation. Also, from the viewpoint of fabrication thereof, it is preferable to use a light within the wavelength region of visible light, not less than 0.4 micron.

In an aspect of increasing the quantity of signal light, necessary for the detection, to improve the signal-to-noise ratio for assuring higher accuracies, the larger the number of bands or rings (number of zones or lines) of a physical optic element is, the better results are obtainable. Since usually each scribe line has a width not greater than 100 microns, use of a light having a wavelength not greater than 2 microns may be preferable.

In an embodiment of the present invention which will be described later, where the first and second objects are a mask and a wafer to be used in a proximity type exposure apparatus or if the spacing d satisfies the relationship: "$d < 5F_1W$" (wherein $F_1$ is an effective F-number of a first physical optic element and W is the size of the aperture of a second physical optic element in the direction of alignment), use is made of a combination of first and second physical optic elements having refracting powers of "positive and negative" or "negative and positive" in the sign.

In that case, the focal lengths f1 and f2 of the first and second physical optic elements can be made longer than the spacing d, and the number of bands of each physical optic element can be made large. Additionally, the linewidth can be made relatively wide.

The structure in which a first physical optic element has a positive refracting power while a second physical optic element has a negative refracting power, has an important feature that, as compared with such a structure in which a first physical optic element has a negative refracting power while a second physical optic element has a positive refracting power, the focal lengths f1 and f2 can be increased slightly, provided that the dimension W of the second physical optic element, imaging magnification $|\beta|$ and the size $\phi$ of the point image or the distance $b_{2a}$ are the same.

On the other hand, the structure in which a first physical optic element has a negative refracting power while a second physical optic element has a positive refracting power, has an important feature that, as compared with such a structure in which a first physical optic element has a positive refracting power while a second physical optic element has a negative refracting power, the region to be occupied by a mark can be reduced.

If the spacing d between the first and second objects satisfies a relationship "d > 5F₁W", preferably a first physical optic element may have a positive refracting power while a second physical optic element may have a positive or negative refracting power.

In that case, if, for example, the size M of the first physical optic element is fixed, the enlargement of the size W of the second physical optic element can be effectively prevented because the spacing d is large.

If, on the other hand, the size W of the second physical optic element is fixed, the reduction in the size M of the first physical optic element (which results in reduction in level of the signal light) can be effectively prevented, such that sufficient diffraction efficiency is attainable.

The structure in which both of first and second physical optic elements have a positive refracting power, has an important feature that, as compared with a case where a first physical optic element has a positive refracting power while a second physical optic element has a negative refracting power, the focal length f1 of the first physical optic element can be reduced by an amount corresponding to $2|a_{2a}|$, provided that the size W of the second physical optic element and the absolute value $|\beta2|$ of the imaging magnification are fixed. As a result, the number of zones (bands) can be increased and, therefore, the diffraction efficiency can be improved.

In a case where the light source 10 (Figure 3) is at a finite distance, the aforementioned value $F_1$ may be determined by the following equation:

$$F_1 = b_{1a}/M$$

where M is the diameter of light emitted from the light source 10 and entering the first physical optic element 3a, and $b_{1a}$ is the distance from the first object to the point of convergence of diffracted light caused by the first physical optic element 3a.

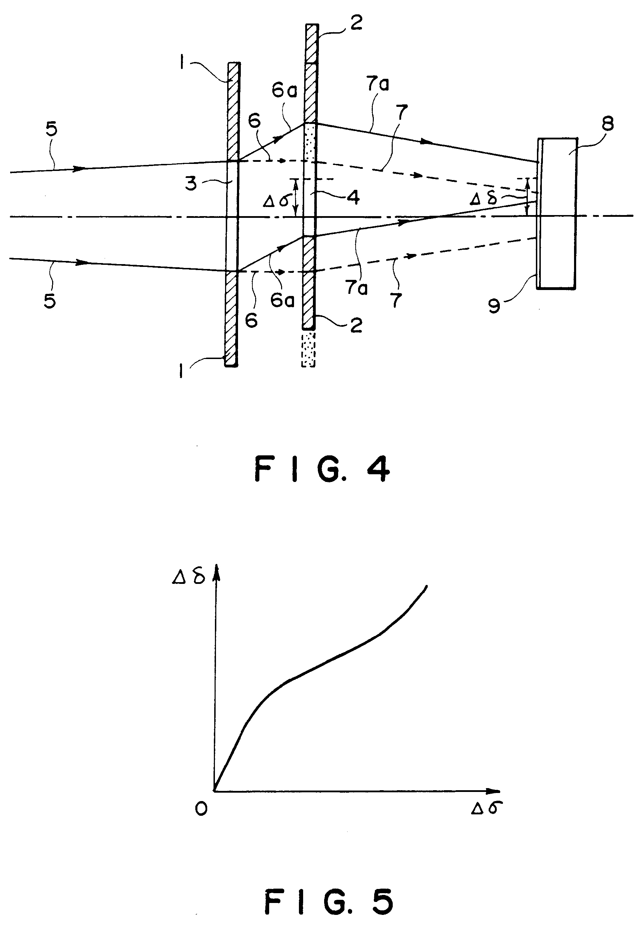

Figure 4 illustrates the fundamental principle of the optical arrangement shown in Figure 3. In Figure 4, first and second physical optic elements 3 and 4 such as zone plates, for example, are provided on first and second objects 1 and 2 with respect to which any relative positional deviation is to be evaluated. Light 5 is projected upon the first physical optic element 3 and light 6 (6a) emanating therefrom impinges on the second physical optic element 4. Light 7 (7a) emanating from the second physical optic element 4 is converged upon a light detecting surface 9 of a detector 8 which may be a position sensor, for example. The detector 8, in this example, comprises a line or linear sensor having sensor elements arrayed in a direction corresponding to the direction with respect to which any positional deviation is to be measured. However, the detector 8 may comprise a two-dimensional or area sensor.

In the Figure 4 example, there occurs upon the detecting surface 9 a deviation $\Delta\delta$ of the center of gravity of light, corresponding to the amount $\Delta\sigma$ of relative positional deviation of the first and second objects 1 and 2.

The term "center of gravity of light" means such a point that, when in the cross-section of the light a position vector of each point in the section is multiplied by the light intensity of that point and the thus obtained products are integrated over the entire section, the integrated value has a "zero vector".

In the Figure 4 example, the position on the detecting surface 9 of the center of gravity of light as depicted by broken lines 7 is used as a reference, and the deviation $\Delta\delta$ of the light depicted by solid lines 7a, upon the detecting surface 9 is detected to thereby determine the relative positional deviation $\Delta\sigma$ of the first and second objects 1 and 2.

The reference position described above can be predetermined. For example, where the first and second objects are a mask and a wafer to be used with a proximity type exposure apparatus and having first and second physical optic elements 3a and 4a, respectively, first the mask having the first physical optic element 3a is held fixed at a suitable position. Then, the wafer having the second physical optic element 4a is placed and roughly aligned with respect to the mask by using suitable means. Thereafter, light is projected upon the first and second physical optic elements, and the position of the center of gravity of light upon the detecting surface 9 in that state is detected. Subsequently, while retaining that state, a pattern of the mask is transferred onto the wafer with suitable radiation energy. The thus transferred pattern is observed by use of a microscope or otherwise, and any pattern overlay error is measured. On the basis of the measured error, the wafer is moved so that it is accurately aligned with the mask. Light is again projected upon the first and second physical optic elements of the thus aligned mask and wafer, and the position of the center of gravity of the light upon the detecting surface 9, as defined at that time, is determined as the reference position.

The output signal from the detector 8 is processed so that it is standardized with respect to the total light intensity on the whole light-receiving region. Accordingly, even when the output power of the light source changes slightly, the measured value as outputted from the sensor system correctly represents the position of center of gravity.

Figure 5 illustrates the relationship between the relative positional deviation $\Delta\sigma$ of the first and second objects 1 and 2 and a deviation or displacement $\Delta\delta$ of the center of gravity of light upon the detecting surface 9.

In an embodiment of the present invention which will be described later, the above-described fundamental principle is utilized to detect the relative position of a first and second objects.

Referring back to Figure 3, where the first and second physical optical elements 3a and 4a and the detecting surface 9 are parallel to each other, a general equation regarding the displacement $\Delta\delta$ corresponding to the positional deviation $\Delta\sigma$ between the first and second objects can be written as below, provided that the position 7c of the center of gravity of the light defined on the detecting surface 9 by a focused light as depicted by broken lines 7 is just in a reference state having no positional error:

$$\Delta\delta = (b_{2a}/a_{2a})(\Delta\sigma 1 + \Delta\sigma 2) + \Delta\sigma 2 \quad (a)$$

wherein

$\Delta\sigma 1$: positional deviation of the first physical optic element 3a from a reference position; and

$\Delta\sigma 2$: positional deviation of the second physical optic element 4a from a reference position.

The signs of $a_{2a}$ and $b_{2a}$ are determined in the following manner:

$a_{2a}$: The distance from the element 4a to the point light source at the light entrance side (including a case where it is imaginary defined at the left-hand side of the element 3a) is positive. It is negative when the light source is a virtual light source; and

$b_{2a}$: The distance from the element 4a to the point of convergence of light at the light entrance side is positive.

Also, the focal length f is f>0, where the lens is a convex lens, while it is f<0 where the lens is a concave lens.

Where the first physical optic element 3a is taken as a reference and when the second physical optic element 4a is deviated by an amount $\Delta\sigma$ in a direction parallel to the first physical optic element 3a, then the deviation $\Delta\delta$ of the center of gravity of the light spot upon the detecting surface 9 can be given by the following equation:

$$\Delta\delta = \Delta\sigma \times (b_{2a}/a_{2a} + 1) \quad (1)$$

Namely, the deviation $\Delta\delta$ of the center of gravity is magnified at an enlarging magnification $\beta$ which is equal to "$b_{2a}/a_{2a} + 1$".

When $a_{2a}$ in this equation is rewritten by using the distance $b_{1a}$ from the first physical optic element to the point Q of convergence and the spacing d between the first and second physical optic elements, it follows that:

$$\beta = [b_{2a}/(d - b_{1a}) + 1]$$

At this time, the focal lengths $f_1$ and $f_2$ of the physical optic elements satisfy the following relations:

$$1/f_1 = 1/a_{1a} + 1/b_{1a}$$
$$1/f_2 = 1/(d - b_{1a}) + 1/b_{2a}$$

When a parallel light is incident, then:

$$a_{1a} = \infty$$
$$\therefore 1/a_{1a} = 0$$
$$\therefore f_1 = b_{1a}$$

Therefore, the enlarging magnification $\beta$ is:

$$\beta = [b_{2a}/(d - f_1) + 1].$$

If, as an example, $a_{2a} = 0.5$ mm and $b_{2a} = 50$ mm, the deviation $\Delta\delta$ of the center of gravity is magnified by 101 (one hundred and one) times larger, in accordance with equation (1).

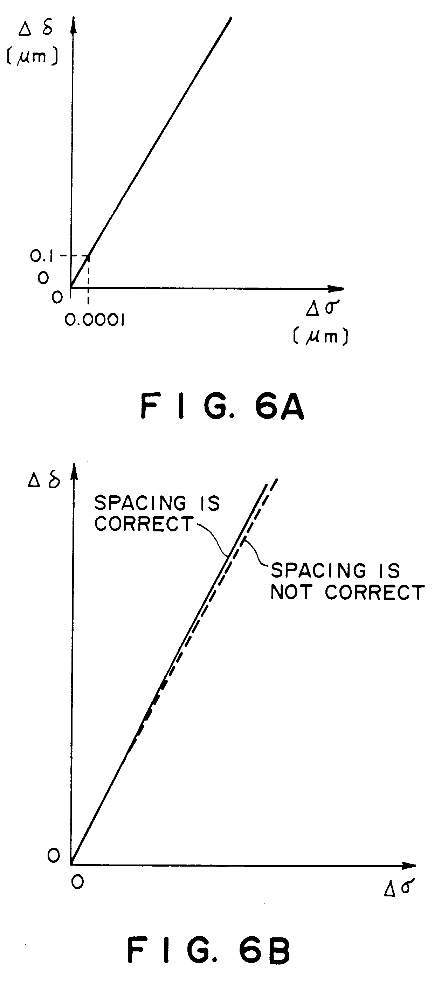

It will be readily understood from equation (1) that the deviation $\Delta\delta$ of the center of gravity and the positional deviation $\Delta\sigma$ at that time are in a proportional relationship such as depicted in Figure 6A. If the detector 8 has a resolution of 0.1 micron, a position resolution of an order of 0.001 micron is obtainable with regard to the positional deviation $\Delta\sigma$.

By moving the second object on the basis of the thus determined positional deviation $\Delta\sigma$, the first and sec-

ond object can be aligned with high precision.

In an embodiment of the present invention, which will be described later, a phase type physical optic element is used as one provided on a first object. By this, the light emanating from that physical optic element can be directed at a good efficiency to a physical optic element on a second object. Additionally, the position of center of gravity of light, upon a predetermined plane, can be detected with high precision.

An alignment process to be adopted in an embodiment of the present invention, which will be described later, may be such as follows:

An example is that: The relationship of a deviation signal $\Delta\delta s$ representing the deviation of center of gravity of light on the detecting surface of the detector 8, with respect to the positional deviation $\Delta\sigma$ between two objects, is predetected and a curve showing that relationship is determined preparatorily. Then, from the value of the deviation signal $\Delta\delta s$, the positional deviation $\Delta\sigma$ between these objects is detected and, thereafter, the first or second object is displaced by an amount corresponding to the detected positional deviation $\Delta\sigma$.

A second example is that: From a deviation signal $\Delta\delta s$ representing the deviation of center of gravity and outputted from the detector 8, the direction that cancels the positional deviation $\Delta\sigma$ is detected. In this direction, the first or second object is displaced, and the above-described process is repeated until the positional deviation $\Delta\sigma$ comes into a tolerable range.

The relationship of the spacing between the first and second physical optic elements 3a and 4a with respect to the deviation $\Delta\delta$ of center of gravity, in an occasion where the spacing is deviated from a predetermined, is such as follows:

When the distance $a_{2a}$ changes due to a deviation or error $\Delta a$ of the spacing, the deviation $\Delta\delta$ of the center of gravity is given by:

$$\Delta\delta = \Delta\sigma \times [b_{2a}/(a_{2a} + \Delta a) + 1]$$

This is illustrated in Figure 6B, wherein, to the positional deviation $\Delta\sigma$, the deviation $\Delta\delta$ of center of gravity is depicted by a slightly shifted straight line that passes through the origin.

This means that, by using the above-described second example of alignment process, in principle the error of spacing does not substantially influence the alignment accuracies.

Further, this implies that, with the first example of alignment process described above, the error in spacing have a small effect upon the alignment accuracies, provided that the positional deviation $\Delta\sigma$ is small.

By way of example, it is now assumed that $a_{2a} = 0.5$ mm, $b_{2a} = 50$ mm, $f = 0.495$ mm and the error $\Delta a$ in the spacing is equal to 5 microns.

Where the spacing does not change, the deviation $\Delta\delta_0$ of the center of gravity of light upon the detecting surface 9 resulting from the positional deviation $\Delta\sigma$, is given by:

$$\Delta\delta_0 = \Delta\sigma \times (50/0.5 + 1) = 101 \cdot \Delta\sigma$$

If, to the contrary, the spacing changes, the deviation $\Delta\delta\Delta a$ of the center of gravity of light is given by:

$$\Delta\delta\Delta a = \Delta\sigma[50/(0.5 + 0.005) + 1] \fallingdotseq 100 \cdot \Delta\sigma.$$

Assuming now that there is a positional deviation $\Delta\sigma = 0.01$ micron, the deviation of the center of gravity of light upon the detecting surface 9, in an occasion where the spacing has changed and in an occasion where the spacing has not changed, is written as follows:

$$\Delta\delta_0 = 101 \times 0.01 = 1.01 \text{ (micron)}$$
$$\Delta\delta\Delta a = 100 \times 0.01 = 1 \text{ (micron)}$$

Namely, the deviation of center of gravity of light on the detecting surface 9 due to the error in the spacing is given by:

$$|\Delta\delta_0 - \Delta\delta\Delta a| = 0.01 \text{ (micron)}.$$

Converting this into the amount of deviation of the physical optic element, it results therefrom that an alignment error is 0.0001 (micron) because the enlarging magnification is x100. Similarly, if the positional deviation $\Delta\sigma$ = 1 micron, the alignment error is 0.01 (micron).

In an occasion where a physical optic element having the function described above is to be provided by an amplitude type zone plate, for example, the configuration of its pattern may be such as described below:

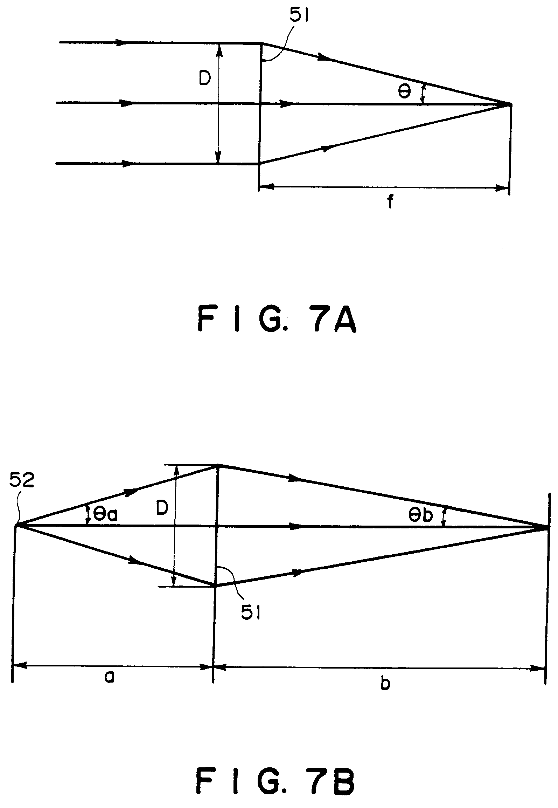

In Figure 7A, a parallel light is projected upon a zone plate 51 having a focal length f and zones (bands) of a number ml and, in this case, the wavelength is denoted by $\lambda$ while the aperture diameter is denoted by D. Then, it follows that:

$$\left. \begin{array}{l} f/\cos\theta - f = mI \cdot \lambda \\ \\ (D/2)/f = \tan\theta \end{array} \right\} \quad \ldots(2)$$

Therefore, the relationship between the ml-th zone with respect to the radius D/2 from the center of the aperture is given by:

$$ml = f/\lambda(\sqrt{(D/2f)^2 + 1} - 1) \quad (2a)$$

For a zone plate which is provided on a second object 2 (Figure 1), such as a zone plate 51 shown in Figure 7B by which a light from a point light source 52 is focused, the following relations are established:

$$\left. \begin{aligned} a(1/\cos\theta a - 1) + b(1/\cos\theta b - 1) &= mII \cdot \lambda \\ D/2a &= \tan\theta a \\ D/2b &= \tan\theta b \end{aligned} \right\} \quad ...(3)$$

It follows therefrom that the relationship of the "mII-th" zone with respect to the radius D/2 from the center of the aperture is represented as follows:

$$mII = a/\lambda(\sqrt{(D/2a)^2 + 1} - 1)$$
$$+ b/\lambda(\sqrt{(D/2b)^2 + 1} - 1) \quad (3a)$$

If, as an example, a light source 10 is a semiconductor laser which supplies light of a wavelength $\lambda = 0.83$ micron, $f = 1000$ microns, $a = 500$ microns and $b = 50000$ microns, then, the number mI of zones of a zone plate 3a to be provided on the first object 1 is equal to 4.9, whereas the number mII of zones of a zone plate 4a to be provided on the second object 2 is equal to 10.4.

Namely, these zone plates may have patterns such as shown in Figures 8A.1 and 8B.1, of which Figure 8A.1 shows a zone plate as the physical optic element 3 while Figure 8B.1 shows a zone plate as the physical optic element 4.

In an embodiment of the present invention which will be described later, in place of amplitude type zone plates shown in Figures 8A.1 and 8B.1, first and second objects are provided with phase type zone plates having similar optical functions and, by using such zone plates, the position of center of gravity of light on a predetermined plane can be detected with high precision.

In case of phase type zone plate, bands (zones) may be set in a similar manner as in the case of the amplitude type zone plate, so as to produce a phase difference corresponding to the quantity of light being transmitted. For example, the thickness of a portion between adjacent bands (painted regions in Figure 8A.1 or 8B.1 example) of an amplitude type zone plate may be modified so that a light beam passing through this portion has a phase difference, shifted by an amount $\pi$ as compared with that of light passing through the band. Examples are shown in Figures 8A.2 and 8B.2.

A phase type grating may be formed in a variety of ways. Examples are as follows:

As a first Example, by using silver salt, an amplitude type grating may be subjected to bleaching treatment to form surface steps (recesses and protrusions). A method using photoresist is well known. There is a method in which a transparent resist is used to form stripe patterns, having an optical path difference of $\lambda/2$ between an area on which resist is present and an area on which no resist is present. Another method is etching treatment using resist to provide surface steps on a substrate. Further, since what is requires is to form a pattern having an optical path difference, such a pattern may be formed by ion doping to change the refractive index of a doped region.

Basically, a phase type grating has a phase difference $\pi$ between adjacent regions. Where the grating is of transmission type, chief rays P1 and P2 for adjacent regions have a phase difference $\Delta\phi$, which can be expressed by an equation set forth below, and the refractive indices n and $n_0$ and thicknesses $d_1$ and $d_2$ are set to satisfy the relation "$\Delta\phi = \pi$".

Phase Difference: $\Delta\phi = (n - n_0)(d_1 - d_2)/\lambda \times 2\pi$ (rad)

In a case of reflection type, on the other hand, chief rays P1 and P2 for adjacent regions, as shown in Figure 8G, have a phase difference $\phi$ which can be expressed by an equation set forth below, and the refractive index $n_0$ and the thickness d are set to satisfy "$\Delta\phi = \pi$".

Phase Difference: $\Delta\phi = 2n_0 d/\lambda \times 2\pi$ (rad)

With a phase type grating, as compared with an amplitude type grating, usually a signal light of an intensity about two times larger than that by the latter is obtainable. For better understanding, reference may be made to Figures 8H and 8I.

When only chief rays from respective apertures are considered, in the point of phase, if the grating is of amplitude type, the rays from the apertures of respective bands are diffracted in the manner as shown in Figure 8H and are focused at a point Q. At this time, each ray from a band has an optical path difference which is

equal to $\lambda$, and there are phase differences of the same amount of $2\pi$. As a result, they are of the same phase. In Figure 8H, for the ray from band 1:

$$u_1 = A_1 e^{j2\pi \cdot \frac{l_1}{\lambda}}$$

For the ray from band 2:

$$u_2 = A_2 e^{j2\pi \cdot \frac{l_2}{\lambda}}$$
$$= A_2 e^{j2\pi \cdot \frac{(l_1 + \lambda)}{\lambda}}$$

For the ray from band m:

$$u_\infty = A_\infty e^{j2\pi \cdot \frac{(l_1 + m\lambda)}{\lambda}}$$

Thus, at point Q, all the rays from the bands are of the same phase and are summed, that is:

$$u = \sum_{i=1}^{n} u_\infty = \left( \sum_{i=1}^{n} A_\infty \right) e^{j 2\pi \cdot \frac{l_1}{\lambda}}$$

Namely, light from an aperture are which is approximately a half of the whole irradiation region of the surface of the element is utilized as a signal light.

As compared therewith, in a phase type grating, as shown in Figure 8I, all the lights from the whole element are utilized as a signal light. Diffraction lights from adjacent regions have an optical path difference of $\lambda/2$, and thus there are phase differences of the same amount of $\pi$. As a result, they are finally of the same phase and are summed. In Figure 8I, for the ray from band 1:

$$u_1 = A_1 e^{j2\pi \cdot \frac{l_1}{\lambda}}$$

For the ray from band 1':

$$u_1' = A_1' e^{j2\pi \cdot \frac{(l_1' + \lambda/2)}{\lambda}}$$
$$= A_1' e^{j2\pi \cdot \frac{(l_1 + \lambda/2 + \lambda/2)}{\lambda}}$$

For the ray from band 2:

$$u_2 = A_2 e^{j2\pi \cdot \frac{l_2}{\lambda}}$$
$$= A_2 e^{j2\pi \cdot \frac{(l_1 + \lambda)}{\lambda}}$$
$$\vdots$$
$$\vdots$$

For the ray from band m:

$$u_\infty = A_\infty e^{j2\pi \cdot \frac{(l_1 + m\lambda)}{\lambda}}$$

For the ray from band m':

$$u_\infty' = A_\infty' e^{j2\pi \cdot \frac{(l_1 + \lambda/2 + \lambda/2 + m\lambda)}{\lambda}}$$

Thus, at point Q, all the rays from the bands are of the same phase and are summed, that is:

$$u = \sum_{i=1}^{n} (u_\infty + u_\infty')$$

$$= \left( \sum_{i=1}^{n} A_\infty + \sum_{i=1}^{n} A_\infty' \right)$$

Namely, all the lights from the whole irradiated region on the surface of the element are utilized to provide a signal. Therefore, as compared with an amplitude type one, a phase type grating can provide a signal light of increased intensity. There does not occur any noise due to the provision of a transmissible portion having a phase difference, in place of a light blocking portion of an amplitude type grating. Therefore, the signal-to-noise ratio can be improved.

Figures 8C and 8D each schematically illustrates a light intensity distribution defined on the detecting surface 9 in an occasion where the aperture of the Fresnel zone plate has a size of 180 x 50 microns and the direction of positional deviation lies in the widthwise direction (in the direction of 180-micron side) of the aperture, and a positional deviation of an amount 25 microns is given. In each of these Figures, an upper half is a birds-eye view and a lower half is a contour map. Figure 8C represents a case where there is no positional deviation, whereas Figure 8D represents a case where a positional deviation of an amount 25 microns is presented.

As will be seen from Figure 8C, where no positional deviation is present, the light intensity distribution is as like as a Fraunhofer diffraction image caused by a substantially rectangular aperture. If there occurs a positional deviation, the distribution is deformed into a slightly asymmetrical pattern, as shown in Figure 8D, in accordance with the amount of deviation.

While in the foregoing examples the amount of shift or deviation of a chief ray, caused optogeometrically, is magnified one hundred times larger than an actual positional deviation. Actually, however, because of aberration of a Fresnel zone plate, the amount of deviation of the center of gravity of light, upon the detecting surface 9 is of a magnitude about ninety-six (96) times larger.

If the positional deviation is large, the positional deviation $\Delta\sigma$ and the deviation $\Delta\delta$ of the center of gravity of light on the detecting surface 9 do not show linearity, and the rectilinear relationship therebetween is damaged slightly.

In consideration of this, the relationship between the positional deviation $\Delta\sigma$ and the deviation $\Delta\delta$ of the center of gravity of light (an example of which relationship is illustrated in Figure 8E) may be memorized preparatorily into a suitable storing means, and the thus stored relationship may be referred to as required. By doing so, it is possible to detect the positional deviation $\Delta\sigma$ at high accuracies and in a wide dynamic range.

Referring now to Figure 9, description will be made of an embodiment of the present invention. This embodiment corresponds to a case where the above-described spacing d satisfies the relationship: "$d \leq 5F_1 \cdot W$", and a first optic element 3b has a light diverging function whereas a second physical optic element 4b has a light converging function. Namely, they provide what can be called a "concave-convex system".

In this embodiment, where the positional deviations of the first and second objects 1 and 2 from respective reference positions are denoted by $\Delta\sigma b_1$ and $\Delta\sigma b_2$, the relative positional deviation $\Delta\sigma b$ can be expressed by:

$$\Delta\sigma b = \Delta\sigma b_1 + \Delta\sigma b_2$$

The deviation $\Delta\delta b$ of the center of gravity of light upon a detecting surface 9, resulting from the positional deviation $\Delta\sigma b$, can be given by:

$$\Delta\delta b = (b_{2b}/a_{2b})\Delta\sigma b + \Delta\sigma b_2$$

Where the first physical optic element 3b is taken as a reference and when the second physical optic element 4b is deviated by an amount $\Delta\sigma$ in a direction parallel to the first physical optic element 3b, then the deviation $\Delta\delta$ of the center of gravity of the light spot upon the detecting surface 9 can be given by the following equation:

$$\Delta\delta = \Delta\sigma \times (b_{2b}/a_{2b} + 1)$$

Namely, the deviation $\Delta\delta$ of the center of gravity is magnified at an enlarging magnification $\beta$ which is equal to "$b_{2b}/a_{2b} + 1$".

When $a_{2b}$ in this equation is rewritten by using the distance $b_{1b}$ from the first physical optic element to the point Q of convergence and the spacing d between the first and second physical optic elements, it follows that:

$$\beta = [b_{2b}/(d - b_{1b}) + 1]$$

At this time, the focal lengths $f_1$ and $f_2$ of the physical optic elements satisfy the following relations:

$$1/f_1 = 1/a_{1b} + 1/b_{1b}$$
$$1/f_2 = 1/(d - b_{1b}) + 1/b_{2b}$$

When a parallel light is incident, then:

$$a_{1b} = \infty$$
$$\therefore f_1 = b_{1b}$$

Therefore, the enlarging magnification $\beta$ is:

$$\beta = [b_{2b}/(d - f_1) + 1].$$

Figure 10 shows another embodiment of the present invention. This embodiment corresponds to a case where the above-described spacing d satisfies the relationship: "$d \leq 5F_1 \cdot W$", and a first physical optic element 3c has a light converging function while a second physical optic element 4c has a light diverging function. Thus, they provide what can be called a "convex-concave system".

In this embodiment, where the positional deviations of a first and second objects 1 and 2 from respective reference positions are denoted by $\Delta\sigma c_1$ and $\Delta\sigma c_2$, the relative positional deviation $\Delta\sigma c$ can be expressed by:

$$\Delta\sigma c = \Delta\sigma c_1 - \Delta\sigma c_2$$

The deviation $\Delta\delta c$ of the center of gravity of light upon a detecting surface 9, resulting from the positional deviation $\Delta\sigma c$ can be given by:

$$\Delta\delta c = (b_{2c}/a_{2c}) \Delta\sigma c - \Delta\sigma c_2$$

Where the first physical optic element 3c is taken as a reference and when the second physical optic element 4c is deviated by an amount $-\Delta\sigma c$ in a direction parallel to the first physical optic element 3c, then the deviation $\Delta\delta$ of the center of gravity of the light spot upon the detecting surface 9 can be given by the following equation:

$$\Delta\delta = (-\Delta\sigma c) \times (b_{2c}/a_{2c} + 1)$$

Namely, the deviation $\Delta\delta$ of the center of gravity is magnified at an enlarging magnification $\beta$ which is equal to "$b_{2c}/a_{2c} + 1$".

When $a_{2c}$ in this equation is rewritten by using the distance $b_{1c}$ from the first physical optic element to the point Q of convergence and the spacing d between the first and second physical optic elements, it follows that:

$$\beta = [b_{2c}/(d - b_{1c}) + 1]$$

At this time, the focal lengths $f_1$ and $f_2$ of the physical optic elements satisfy the following relations:

$$1/f_1 = 1/a_{1c} + 1/b_{1c}$$
$$1/f_2 = 1/(d - b_{1c}) + 1/b_{2c}$$

When a parallel light is incident, then:

$$a_{1c} = \infty$$
$$\therefore f_1 = b_{1c}$$

Therefore, the enlarging magnification $\beta$ is:

$$\beta = [b_{2b}/(d - f_1) + 1].$$

The optical arrangement may be appropriately selected, in accordance with the spacing between the first and second objects 1 and 2 and the magnitude of the apertures of the first and second physical optic element. For example, where the spacing is sufficiently large as compared with the apertures of the first and second physical optic elements, the "convex-convex system" such as shown in Figure 3 or a "convex-concave system" such as shown in Figure 10 is preferable. On the other hand, where the spacing is not sufficiently large as compared with the apertures (typically in a case of a mask and a wafer to be used in a proximity type exposure apparatus), a "concave-convex system" such as shown in Figure 9 or a "convex-concave system" such as shown in Figure 10 is preferable.

Further, in an occasion where the aperture of a second physical optic element can be made larger than that of a first physical optic element, as in the Figure 9 example, a "concave-convex system" such as shown in the same Figure is preferable. On the other hand, where the aperture of a first physical optic element can be made larger than that of a second physical optic element, as in the Figure 10 example, a "convex-concave system" such as shown in the same Figure is preferable.

While the foregoing embodiments use transmission type physical optic elements, the objects and advantageous features of the present invention can be accomplished as a matter of course by using reflection type physical optic elements.

Referring now to Figure 11A, description will be made of an embodiment of the present invention. In this embodiment, the invention is applied to an alignment system incorporated into a semiconductor device manufacturing exposure apparatus of proximity exposure type, for aligning a mask M and a wafer W.

In Figure 11A, same reference numerals as of Figure 3 are assigned to similar or corresponding elements. In Figure 11A, reference character M denotes a mask and reference character W denotes a wafer, which correspond respectively to a first and second objects to be relatively aligned. Reference character 3M denotes a mask alignment pattern which is formed on the mask M and which corresponds to a first physical optic element. Reference character 4W denotes a wafer alignment pattern provided on the wafer W and it corresponds to a second physical optic element of reflection type.

The embodiment shown in Figure 11A provides what can be called a "concave-convex system" which corresponds to an optical arrangement having a concave lens and a concave-surface mirror. The mask M is attached to a membrane 17 which is supported through a mask chuck 16 by a main frame member 15 of the exposure apparatus. Disposed above the frame member 15 is a mask-to-wafer alignment head 14. For alignment of the M and the wafer W, a mask alignment pattern 3M and a wafer alignment pattern 4W are provided on the mask M and the wafer W, by lithographic technique, for example.

The wafer W is supported by a wafer chuck 20. Detector 8 is provided, which produces an output signal that is applied to a signal detecting circuit 24. In this signal detecting circuit 24, the position of the center of gravity of light is detected, and a signal corresponding to any positional deviation is supplied to a control device 23. In response to the supplied signal, the control device 23 produces and applies an instruction signal to a wafer stage controller 22 to cause the same to controllably move, in an appropriate direction or directions, a wafer stage 21 together with the wafer chuck 20 fixedly mounted thereto. The position of the wafer stage 21 is measured and monitored constantly by use of a laser interferometer measuring system, not shown.

Light emanating from a light source 10 is collimated into a parallel light by a lens system 11, and after passing through a half mirror 12 the parallel light impinges upon the mask alignment pattern 3M. The mask alignment pattern 3M is provided, in this embodiment, by a zone plate of transmission type and is adapted to transform

EP 0 333 326 B1

a received light into a diverging light like a beam as divergingly emitted from a point Q. Thus, the mask alignment pattern 3M has a function of a concave lens, for divergingly projecting light upon the wafer alignment pattern 4W. The wafer alignment pattern 4W is provided, in this embodiment, by a zone plate of reflection type and has a function of a concave mirror for imaging, upon the detecting surface 9, the light as emanating from the point Q.

Where, in such arrangement, the wafer W is positionally deviated by an amount $\Delta\sigma w$ with respect to the mask M, the displacement or positional deviation $\Delta\delta w$ of the center of gravity of light upon the detecting surface 9 can be written as follows:

$$\Delta\delta w = \Delta\sigma w \times (bw/aw + 1)$$

Rewriting aw in this equation by using the distance $b_{1b}$ from the first physical optic element to the point of convergence and the spacing d between the first and second physical optic elements, then,

$$\beta = [bw/(d - b_{1b}) + 1]$$

At this time, the focal lengths $f_1$ and $f_2$ of these physical optic elements satisfy the following relations:

$$1/f_1 = 1/a_{1b} + 1/b_{1b}$$
$$1/f_2 = 1/(d - b_{1b}) + 1/bw$$

Where a parallel light is used for illumination,

$$a_{1b} = \infty$$
$$\therefore f_1 = b_{1b}$$

Thus, the enlarging magnification $\beta$ is

$$\beta = [bw/(d - f_1) + 1]$$

Details of the alignment procedure in this embodiment will now be explained.

(1-1) First, a reference point for accomplishment of alignment is set. As for such a reference point, a particular position on the detecting surface 9 can be determined preparatorily, for example, in the manner described hereinbefore. The following some steps are for the mask alignment.

(1)-(a) A reference mark 25 which may be formed by a grating lens similar to the wafer pattern, is formed on the wafer chuck 20 which is mounted to the wafer stage 21.

(1)-(b) Control device 23 applies a moving signal to the wafer stage controller 22 to move the wafer stage 21 so as to bring the reference mark 25 to an alignment evaluation station. The reference mark 25 is thus moved to and stopped at such a position at which, when the alignment pattern 3M of the mask is correctly positioned at a set position, the position of the center of gravity of light projected upon these marks is exactly coincident with the reference point.

(1)-(c) Then, the light from the light source 10 is projected upon the mask alignment pattern 3M and the reference pattern 25, the light passing through these patterns being concentrated upon the detecting surface 9.

(1)-(d) The position detecting circuit 24 detects the position of the center of gravity of the thus focused light, and supplies a position signal to the control device 23. Based on the thus supplied position signal, the control device 23 actuates a driving mechanism (not shown) to move and correctly position the mask.

(1-2) Subsequently, by moving the wafer stage 21, the position of the wafer W is set so that the wafer alignment pattern 4W is placed at the alignment evaluation station.

(1-3) Then, light is projected from the light source 10 upon the mask alignment pattern 3M and then upon the wafer alignment pattern 4W, the light passing these patterns being directed to the detecting surface 9. The signal detecting circuit 24 detects the position of the center of gravity of incident light, the supplies a wafer position signal to the control device 23.

(1-4) The control device evaluates the positional error or deviation of the wafer, on the basis of the reference point position and the wafer position signal, and supplies an alignment signal to the wafer stage controller 22.

(1-5) The wafer stage controller 22 operates to move the wafer stage 21 to correct the relative positional deviation between the mask and the wafer.

(1-6) Again, any positional deviation between the mask and the wafer is examined or checked.

(1-7) If necessary, the above-described steps (1-2) to (1-6) are repeated.

The manner of control of the control device 23 according to the above-described alignment procedure is shown in Figure 11B.

Figure 12 shows another embodiment of the present invention which is similar to the Figure 11A embodiment but which uses what can be called a "convex-concave arrangement" corresponding to one as having a convex lens and a convex-surface mirror.

Mask M is attached to a membrane 17 which is supported through a mask chuck 16 by a main frame member 15 of the exposure apparatus. Disposed above the frame portion 15 is a mask-to-wafer alignment head

13

14. For alignment of the mask M and a wafer W, a mask alignment pattern 3M and a wafer alignment pattern 4M are provided on the mask M and the wafer W, respectively, by using lithographic technique, for example.

Light emanating from a light source 10 is collimated into a parallel light by a lens system 11, and after passing through a half mirror 12 the parallel light impinges upon the mask alignment pattern 3M. The mask alignment pattern 3M is provided, in this embodiment, by a zone plate of transmission type and has a function of a concave lens for converging a received light toward a point Q. The wafer alignment pattern 4W is provided, in this embodiment, by a zone plate of reflection type and has a function of a convex mirror for imaging, upon the detecting surface 9, the light as coming thereto to be converged at the point Q.

Where, in such arrangement, the wafer W is positionally deviated by an amount $\Delta\sigma w$ with respect to the mask M, the displacement or positional deviation $\Delta\delta w$ of the center of gravity of light upon the detecting surface 9 can be written as follows:

$$\Delta\delta w = \Delta\sigma w \times (bw/aw - 1)$$
$$= (-\Delta\sigma w)[bw/(-aw) + 1]$$

Namely, the deviation $\Delta\delta w$ of the point of convergence is magnified by an enlarging magnification $\beta$ which can be given by:

$$\beta = [bw/(-aw) + 1]$$

Rewriting aw in this equation by using the distance $b_{1c}$ from the first physical optic element to the point of convergence and the spacing d between the first and second physical optic elements, then,

$$\beta = [bw/(d - b_{1c}) + 1]$$

At this time, the focal lengths $f_1$, and $f_2$ of these physical optic elements satisfy the following relations:

$$1/f_1 = 1/a_{1c} + 1/b_{1c}$$
$$1/f_2 = 1/(d - b_{1c}) + 1/bw$$

Where a parallel light is used for illumination,

$$a_{1c} = \infty$$
$$\therefore f_1 = b_{1c}$$

Thus, the enlarging magnification $\beta$ is

$$\beta = [bw/(d - f_1) + 1]$$

Figure 13 shows a further embodiment, wherein like some of the foregoing embodiments the invention is applied to a proximity type exposure apparatus.

In this embodiment, in place of a reflection type zone plate which is used in the Figure 11A embodiment as a wafer alignment pattern, a reflection type pattern 4W formed by shaping a surface portion into a concave surface is used. The function thereof is substantially the same as that of the reflection type zone plate used in the Figure 11A embodiment.

Reference character 3M denotes a mask alignment pattern which is provided in this embodiment by a transmission type zone plate. The remaining structure is substantially the same as that of the Figure 11A embodiment.

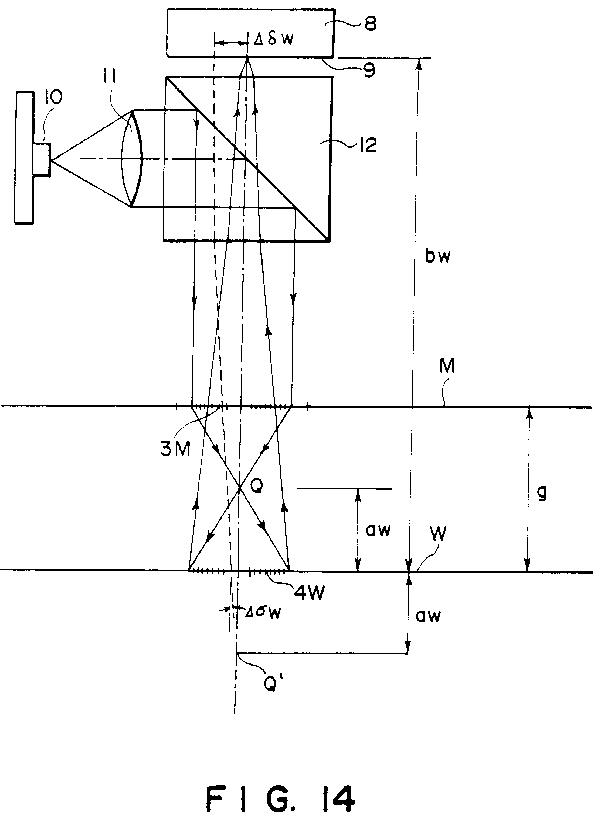

Figure 14 shows a yet another embodiment, wherein like some of the foregoing embodiments the invention is applied to a proximity type exposure apparatus. This embodiment has a structure which corresponds to what can be called a "convex-convex arrangement" having a convex lens and a concave-surface mirror.

Light emanating from a light source 10 is collimated into a parallel light by a lens system 11, and after passing through a half mirror 12 the parallel light impinges upon the mask alignment pattern 3M. The mask alignment pattern 3M is provided, in this embodiment, by a zone plate having a function for focusing a received light at a point Q which is before a wafer W. The light once focused at the point Q advances divergently and impinges on a wafer alignment pattern 4W. The wafer alignment pattern 4W is provided, in this embodiment, by a zone plate of reflection type and has a function for reflecting a received light so that, after passing the mask M and the half mirror 12, it is imaged on a detecting surface 9.

In this embodiment, as discussed, the light focused at the point Q by the mask alignment pattern is then imaged upon the detecting surface 9. If in this case the wafer W is positionally deviated by an amount $\Delta\sigma w$ with respect to the mask M, the displacement or positional deviation $\Delta\delta w$ of the center of gravity of light upon the detecting surface 9 can be written (similarly to the case of the "convex-convex system" shown in Figure 3) as follows:

$$\Delta\delta w = \Delta\sigma w \times (bw/aw + 1)$$

Rewriting aw in this equation by using the distance $b_{1a}$ from the first physical optic element to the point Q′ of convergence and the spacing d between the first and second physical optic elements, then,

$$\beta = [bw/(d - b_{1a}) + 1]$$

At this time, the focal lengths $f_1$, and $f_2$ of these physical optic elements satisfy the following relations:

$$1/f_1 = 1/a_{1a} + 1/b_{1a}$$
$$1/f_2 = 1/(d - b_{1a}) + 1/bw$$

Where a parallel light is used for illumination,

$$a_{1a} = \infty$$
$$\therefore f_1 = b_{1a}$$

Thus, the enlarging magnification $\beta$ is expressed as follows:

$$\beta = [bw/(d - f_1) + 1]$$

Where the gap g between the mask M and the wafer W is 50 microns and where

$$aw = 25 \text{ microns}$$
$$bw = 10000 \text{ microns},$$

then a sensitivity of four hundreds and one (401) times higher is obtainable. Namely, if the measurement is attainable with a precision of $\Delta\delta w = 0.1$ micron, then, a least positional deviation $\Delta\sigma w$ to 0.00025 micron can be evaluated.

If, at this time, an alignment pattern of a diameter of 30 microns is used, the minimum pitch P is can be given by:

$$P = \lambda/\sin\theta = 0.83/\sin 30°$$
$$= 1.66 \text{ micron}$$

Thus, the minimum line width is 0.83 micron.

Also, if the effective diameter of the spot is determined by using $e^{-2}$, the spot diameter S on the detecting surface 9 can be given by:

$$S = 1.64 \times \lambda \cdot F_{NO.}$$
$$= 1.64 \times 0.83 \times 10000/30$$
$$= 454 \text{ (microns)}$$

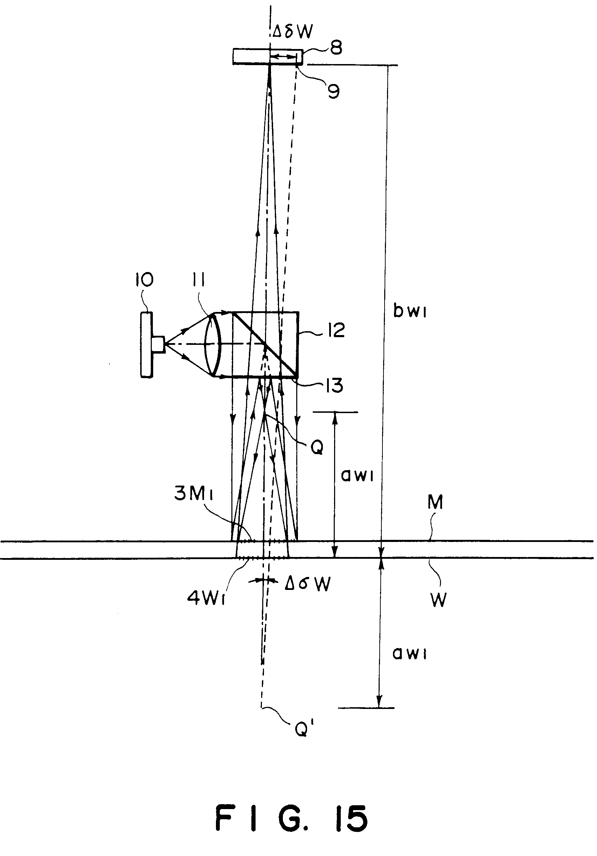

Figure 15 shows a still further embodiment of the present invention, wherein like some of the foregoing embodiments the invention is applied to an exposure apparatus of proximity type. This embodiment has a structure which corresponds to what can be called a "convex-convex arrangement" having two concave-surface mirrors.

Light emanating from a light source 10 is collimated into a parallel light by a lens system 11, and after passing through half mirrors 12 and 13 the parallel light impinges upon a mask alignment pattern 3M1. The mask alignment pattern 3M1 is provided, in this embodiment, by a grating lens of reflection type and is adapted to reflect a received light so that, after being reflected again by the half mirror 13, the light is focused at a point Q. The light emanating from the point Q is further reflected by a wafer alignment pattern 4W provided on a wafer W. After passing the half mirrors 12 and 13, the reflected light from the wafer alignment pattern is focused upon a detecting surface 9.

Where, in such arrangement, the wafer W is positionally deviated by an amount $\Delta\sigma w$ with respect to the mask M, the displacement or positional deviation $\Delta\delta w$ of the center of gravity of light upon the detecting surface 9 can be written as follows:

$$\Delta\delta w = \Delta\sigma w \times (bw1/aw1 + 1)$$

Assuming now that $aw1 = 0.5$ mm and $bw1 = 50$ mm, then $\Delta\delta w = 101\Delta\sigma w$. Namely, if the measurement can be made at a precision of $\Delta\delta w = 0.1$ micron, a least positional deviation $\Delta\sigma w$ to 0.001 micron can be evaluated.

Also, if the aperture of the wafer alignment pattern 4W is sized to 100 microns, the spot diameter $\phi$ on the detecting surface 9 becomes equal to 680 microns, provided that the evaluation is made to the extent of such a diameter at which, due to the diffraction effect, the light quantity decreases to $e^{-2}$ on condition that $\lambda = 0.83$ micron and on condition that an image formed at the point Q is a point image. Since actually there is a substantial expansion in an image formed by the mask alignment pattern 3M1, this effect is more significant.

If the expansion at this time is 10 microns, then $\phi = 1000$ microns.

Figure 16 shows a yet another embodiment of the present invention, wherein the invention is applied to an alignment system in a proximity type exposure apparatus, for aligning a mask and a wafer.

Details of the alignment procedure in this embodiment will now be explained.

(1-1) First, a reference point for accomplishment of alignment is set. As for such a reference point, a particular position on the detecting surface 9 can be determined preparatorily, for example, in the manner described hereinbefore. The following some steps are for the mask alignment.

(1)-(a) A reference mark 25 which may be formed by a grating lens similar to the wafer pattern, is formed on the wafer chuck 20 which is mounted to the wafer stage 21.

(1)-(b) Control device 23 applies a moving signal to the wafer stage controller 22 to move the wafer stage 21 so as to bring the reference mark 25 to an alignment evaluation station. The reference mark 25 is thus moved to and stopped at such a position at which, when the alignment pattern 3M of the mask is correctly positioned at a set position, the position of the center of gravity of light projected upon these marks is exactly coincident with the reference point.

(1)-(c) Then, the light from the light source 10 is projected upon the mask alignment pattern 3M and the reference pattern 25, the light passing through these patterns being concentrated upon the detecting surface 9.

(1)-(d) The position detecting circuit 24 detects the position of the center of gravity of the thus focused light, and supplies a position signal to the control device 23. Based on the thus supplied position signal, the control device 23 actuates a driving mechanism (not shown) to move and correctly position the mask.

(1-2) Subsequently, by moving the wafer stage 21, the position of the wafer W is set so that the wafer alignment pattern 4W is placed at the alignment evaluation station.

(1-3) Then, light is projected from the light source 10 upon the mask alignment pattern 3M and then upon the wafer alignment pattern 4W, the light passing through these patterns being directed to the detecting surface 9. The signal detecting circuit 24 detects the position of the center of gravity of incident light, and supplies a wafer position signal to the control device 23.

(1-4) The control device evaluates the positional error or deviation of the wafer, on the basis of the reference point position and the wafer position signal, and supplies an alignment signal to the wafer stage controller 22.

(1-5) The wafer stage controller 22 operates to move the wafer stage 21 to correct the relative positional deviation between the mask and the wafer.

(1-6) Again, any positional deviation between the mask and the wafer is examined or checked.

(1-7) If necessary, the above-described steps (1-2) to (1-6) are repeated.

The manner of control of the control device 23 according to the above-described alignment procedure is shown in Figure 17.

Figure 18 shows a still further embodiment of the present invention, wherein the invention is applied to a semiconductor device manufacturing exposure apparatus of reduction projection type.

In Figure 18, light emanating from a light source 10 is collimated into a parallel light by a lens system 11, and the parallel light illuminates a reticle alignment pattern 3L provided on a reticle L. In this embodiment, the reticle alignment pattern 3L constitutes a transmission type physical optic element having a lens function for focusing the light passing therethrough at a point Qo. The light from the point Qo is directed by a reduction lens system 18 to be focused at a point Q which is spaced by a distance aw from a wafer W.

The wafer W is provided with a wafer alignment pattern 4W which constitutes, in this embodiment, a reflection type physical optic element having a function, like that of a convex-surface mirror, for reflecting the light, coming thereto so as to be focused at the point Q, so that with the cooperation of a half mirror 19 the reflected light is focused on a detecting surface 9.

On the basis of any deviation $\Delta\delta$ of the center of gravity of light incident on the detecting surface 9, any relative positional deviation $\Delta\sigma$ between the reticle L and the wafer W is detected.

Where the distance from the wafer W to the detecting surface 9 via the half mirror 19 is denoted by bw, the deviation $\Delta\delta$ of the center of gravity of light can be given by:

$$\Delta\delta = \Delta\sigma \times (bw/aw - 1)$$

By suitably selecting the distances aw and bw, the relative positional deviation $\Delta\sigma$ of the reticle L and the wafer W can be detected with high precision.

In this embodiment, the position of the point Q is located at a side of the wafer W remote from the reticle L and the wafer alignment pattern 4W used is of a convex-surface mirror type, this is not limiting. Namely, as shown in Figures 11A and 14, the point Q may be defined on another side of the wafer, close to the reticle L, and the wafer alignment pattern 4W may be of a concave-surface mirror type. Substantially the same results are obtainable in that case.

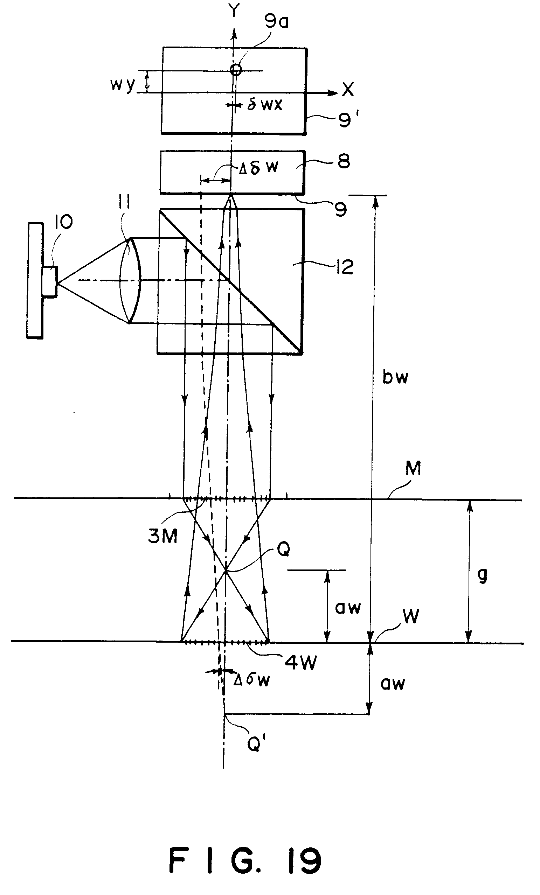

Figure 19 shows a further embodiment of the present invention, which is similar to the Figure 14 embodiment. In this embodiment, the alignment patterns of the mask and the wafer of the Figure 14 embodiment are modified. More specifically, a mask alignment pattern 3M and a wafer alignment pattern 4W each is formed by a two-dimensional grating having the same refracting power both in the direction of scribe line and in the direction perpendicular thereto.

Detector 8 comprises a two-dimensional or area sensor and functions to detect the position of the center of gravity of light incident thereupon. Reference numeral 9′ denotes a light-receiving surface of the detector 8, and reference numeral 9a denotes the spot formed by the light incident on the detector 8. In this embodiment, the detector 8 is adapted to detect any positional deviation between the mask M and the wafer W, two-dimensionally and at a magnification which is defined by the grating system. By using such a two-dimensional grating lens system and such a two-dimensional sensor, the direction and the amount of the positional deviation between the mask and the wafer can be detected at a time and with high precision.

In the sensor system, as has been described with reference to Figure 3, the signal is processed to be standardized with the total light intensity over the whole light-receiving region. As a result, even if the output power of the light source changes slightly, the measured value as outputted from the sensor system exactly represents the position of the center of gravity.

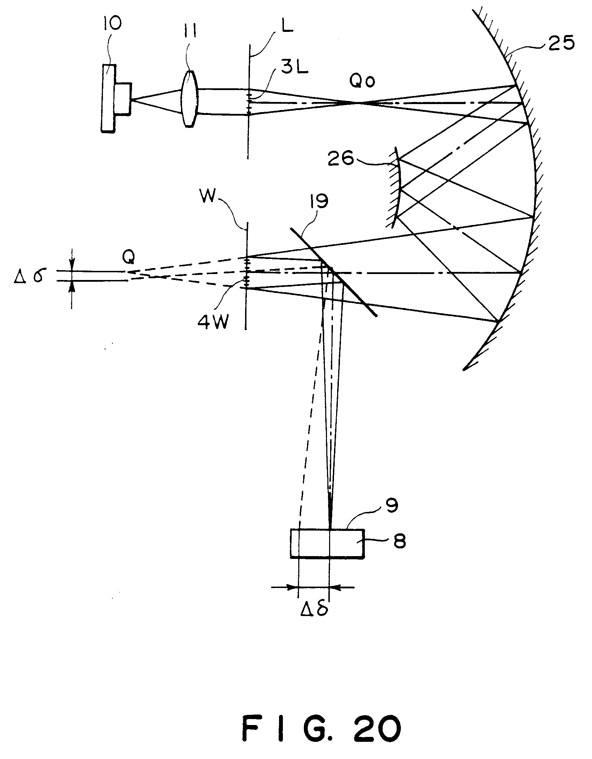

Figure 20 shows a yet further embodiment of the present invention, wherein the invention is applied to a semiconductor device manufacturing exposure apparatus of unit-magnification imaging type using two reflection mirrors 25 and 26. In this embodiment, a pattern (circuit pattern) formed on a reticle L is imaged by the reflection mirrors 25 and 26 upon a wafer W surface and, for this purpose, a printing light or radiation energy emitted from an exposure system (not shown in this drawing) is used to print the reticle pattern on the wafer W surface.

On the other hand, an alignment system is arranged so that light emanating from a light source 10 is collimated into a parallel light by a lens 11 and the collimated light, after passing through a reticle alignment pattern 3L on the reticle L, is directed by the reflection mirrors 25 and 26 to illuminate a wafer alignment pattern 4W. Then, it is reflected by the wafer alignment pattern 4W and is again reflected by a half mirror 19. Thereafter, the light is directed to a detecting surface 9 of a detector 8. In this embodiment, the reticle alignment pattern 3L and the wafer alignment pattern 4W each is formed by a physical optic element having optical characteristics suitable to or according to the present invention. More specifically, the reticle alignment pattern has a function of a convex lens, so that the light which is focused once at a point Qo is focused again at a point Q by the action of the reflection mirrors 25 and 26. On the other hand, the wafer alignment pattern 4W has a function of a convex-surface mirror and operates to reflect the light, coming thereto so as to be focused at the point Q, and focus the light upon the detecting surface 9.

On the basis of any deviation $\Delta\delta$ of the center of gravity of light incident upon and detected by the detecting surface 9, any relative positional deviation $\Delta\sigma$ of the reticle L and the wafer W is detected essentially in the same manner as in the foregoing embodiments.

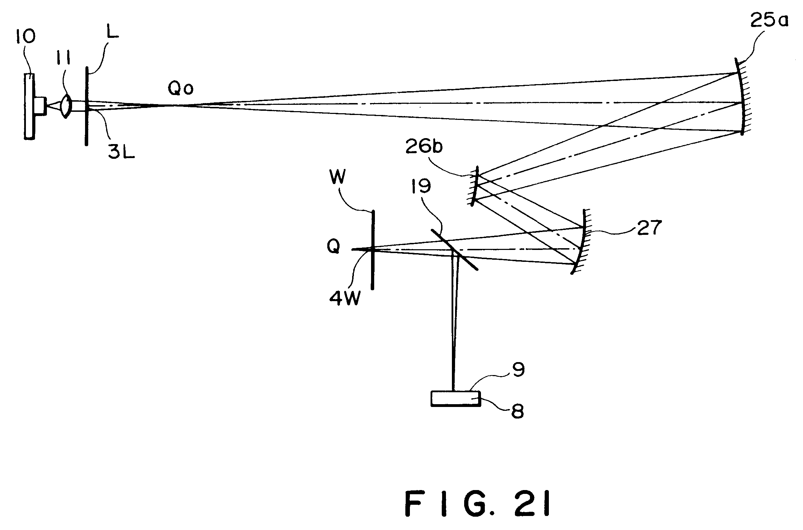

Figure 21 shows another embodiment, wherein the invention is applied to a semiconductor device manufacturing exposure apparatus of reduction imaging type, using three reflection mirrors 25a, 26a and 27.

In this embodiment, a pattern (circuit pattern) formed on a reticle L is imaged in a reduced scale of 1:4 upon the surface of a wafer W, by means of the reflection mirrors 25a, 26a and 27. At this time, a printing light or radiation energy supplied by an exposure system (not shown in this drawing) is used to print the reticle pattern on the wafer W surface.

On the other hand, an alignment system is arranged so that light emanating from a light source 10 is collimated into a parallel light by a lens 11, and the reflected light, after passing through a reticle alignment pattern 3L provided on the reticle L, is directed by the reflection mirrors 25a, 26a and 27 to illuminate a wafer alignment pattern 4W. The light is reflected by the wafer alignment pattern 4W and is reflected again by a half mirror 19. Thereafter, it is directed to a detecting surface 9 of a detector 8. In this embodiment, the reticle alignment pattern 3L and the wafer alignment pattern 4W each is provided by a physical optic element having optical characteristics suitable to or according to the present invention. More specifically, the reticle alignment pattern 3L has a function of a convex lens, so that the light which is focused once at a point Qo is focused again at a point Q by the action of the reflection mirrors 25a, 26a and 27. The wafer alignment pattern 4W has a function of a convex-surface mirror and reflects the light, coming thereto so as to be focused at the point Q, and focuses it upon the detecting surface 9.

On the basis of any deviation $\Delta\delta$ of the center of gravity of light incident on and detected by the detecting surface 9, any relative positional deviation $\Delta\sigma$ of the reticle L and the wafer W is detected essentially in the same manner as in the foregoing embodiments.

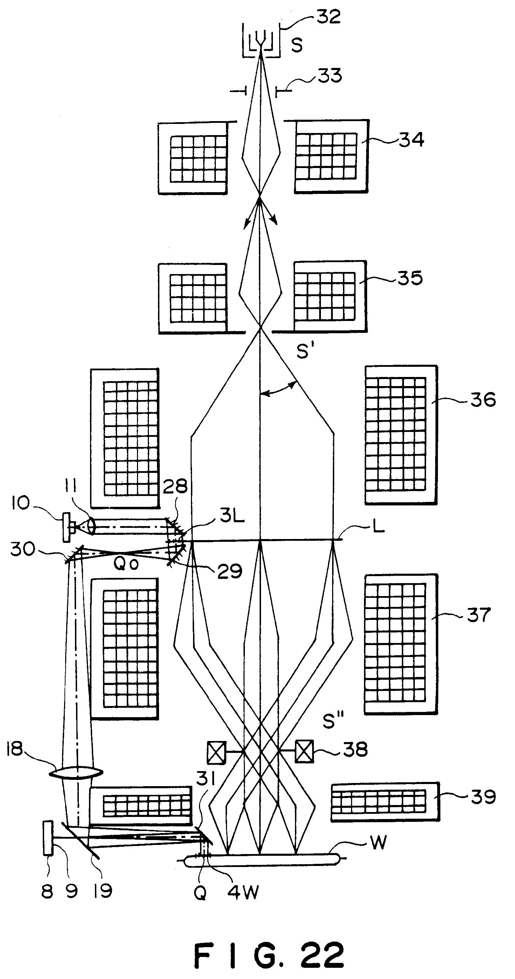

Figure 22 shows a further embodiment of the present invention, wherein the invention is applied to an electron-beam irradiation apparatus of reduction projection type, for use in the manufacture of semiconductor devices.

In this embodiment, an electron beam projected by an electron gun 32 passes through a blanking plate 33 and then is transformed into a parallel beam by means of a first condenser lens 34, a second condenser lens 35 and a third condenser lens 36. Thus, a parallel electron beam irradiates a reticle L. The reticle L is provided by a pattern which can be prepared by forming shaped or patterned holes in a metallic foil. The electron beam passing through the reticle L forms, in cooperation with a first projection lens 37, an apertured alignment coil 38 and a second projection lens 39, an image of a mask pattern upon the surface of a wafer W in a reduced scale of 1:10, in this embodiment.

On the other hand, an alignment optical system is arranged so that light emanating from a light source 10, provided for the alignment purpose, is collimated into a parallel light by a lens 11, and the parallel light is projected by a mirror 28 upon an alignment pattern 3L provided on the reticle L. By this alignment pattern 3L, the parallel light is converged to and focused at a point Qo, after once reflected by a mirror 29. Subsequently, the advancing direction of the light is changed by a mirror 30 and, by a lens 18, the light is again transformed into a convergent light. Then, while the advancing direction is changed successively by a half mirror 19 and a mirror 31, the light is converged toward a point Q. Alignment pattern 4W provided on the wafer W functions to reflect the light, converging toward the point Q, so that by way of the mirror 31 and the half mirror 19, the light is focused on a detecting surface 9 of a detector 8.

In this embodiment, the reticle alignment pattern is so sized that, by the lens 18, it is brought into a reduction projection relationship of a reduction scale of 10:1, as the same magnification of the electron beam exposure system. As a result, any lateral shift of the circuit pattern provided on the reticle corresponds, in a one-to-one relationship, to the lateral shift of the reticle alignment pattern 3L.

On the basis of any deviation $\Delta\delta$ of the center of gravity of light incident on and detected by the detecting surface 9, any relative positional deviation $\Delta\sigma$ of the reticle L and the wafer W is detected essentially in the same manner as in the foregoing embodiments.

Referring now to Figures 23A - 23C, the principle of alignment in an example where the invention is applied to a reticle-to-wafer alignment in a projection type exposure apparatus, like that shown in Figure 18, will be explained in greater detail. Like numerals as of Figure 18 are assigned to similar elements.

Of these drawings, Figures 23A and 23C depict occasions in each of which a first object (reticle) L and a second object (wafer) W are relatively deviated by an amount $\Delta\sigma$. Figure 23B depicts a state in which the alignment of the first and second objects L and W is completed.

In this example, a parallel light from a collimator lens (not shown) is projected upon a first physical optic element 3L such as a Fresnel zone plate, for example, which is a first alignment pattern provided in a portion of the first object L (which represents a reticle). The first physical optic element 3L has a light converging function as of a convex lens, for example, so that the light emanating therefrom is focused at a focal point position $Q_0$ of the first physical optic element 3L. Such point $Q_0$ is relayed by means of a condensing optical system such as, for example, a projection lens system 18 provided for the reduction printing, whereby the focused light at the point $Q_0$ is re-imaged at a point Q.

In this example, the second object W such as a wafer which is a subject to be aligned, is disposed on the lens system 18 side of the point Q and at a distance aw from the point Q. Additionally, in such region of the second object W surface that can be irradiated with the light being converged toward the point Q, a second physical optic element 4W having a light diverging function such as of a convex lens, for example, is provided. The light incident on the second physical optic element 4W is reflected, whereby, through the reflection at an unshown half mirror, the point Q is re-imaged upon a detecting surface 9 as a point R.

Namely, the first physical optic element 3L, the lens system 18 and the second physical optic element 4W are arranged so as to provide a lens group of what can be called a "convex-convex-concave system" type, such that a projected light image is once imaged at a midway (point $Q_0$) and, thereafter, it is focused by the lens system 18 at a point Q spaced by a distance aw from the second physical optic element 4W, the point Q being re-imaged upon the detecting surface 9, as a point R, which is spaced by a distance bw from the second physical optic element 4W. Where, in this example, the center of the second physical optic element 4W is denoted by O and where the amount of shift of the positional relationship between the first and second objects L and W (as shown in Figure 23A or 23C) from their positional relationship to be assumed at the time of completion of the alignment, namely, the amount of positional deviation between the first and second objects, is denoted by $\Delta\sigma$, then it is easily seen from the geometrical arrangement that the amount of displacement ($\Delta\delta$) of the imaging point R upon the detecting surface 9 from the position as assumed at the time of completion of the alignment, can be given by the following equation, provided that parameters are set as illustrated in the drawings:

$$\Delta\delta = (1 - bw/aw)\cdot\Delta\sigma \quad (4)$$

wherein, in Figures 23A - 23C, $\Delta\sigma > 0$, aw > 0, bw > 0 and $\Delta\delta < 0$. In equation (4), bw/aw corresponds to a lateral magnification $\beta$ (which can be called an imaging magnification) used in an ordinary optical imaging system. Thus, equation (4) can be rewritten as follows:

$$\Delta\delta = (1 - \beta)\cdot\Delta\sigma \quad (5)$$

The position of the imaging point R as assumed at the time of alignment completion can be determined in preparation. For example, each time a fresh mask is introduced to the exposure apparatus, trial printing of a wafer or wafers may be made. From any deviation of a printed pattern, after the development, as well as the position of the imaging point as assumed at the time of trial printing, the reference position for the imaging point R can be detected by using equation (5).

It will be readily understood from equations (4) and (5) that, for high-precision detection of any displacement of the second object W, it is preferable to enlarge the amount of shift ($\Delta\delta$) of a light spot formed on the light receiving surface 9. For example, a magnification x50 - x200, for example, may be preferably set for a positional deviation $\Delta\sigma$. This can be defined substantially only by the distance aw to the imaging point Q and the distance bw to the detecting surface 9, in combination with the imaging magnification of the lens system 18, while taking the focal length of the first physical optic element 3L as a parameter. Therefore, a desired magnification can be easily set in consideration of limitations determined in respect to the fabrication of the apparatus. For convenience in explanation, description has been made of an example wherein light from the second physical optic element 4W is directly imaged upon the detecting surface 9. However, if there is a difficulty in the disposition of the detecting surface 9 from some limitations in regard to the fabrication, for example, a suitable lens system may of course be provided at a midway of the optical path so as to adjust the operative distance, to thereby adjust the magnification.

In the present embodiment, each alignment pattern comprises a physical optic element. This is advantageous because, as compared with a case where an alignment pattern comprises a traditional edged pattern, the alignment is less affected by any defect of the alignment pattern. Further, the focal length of the first physical optic element can be selected so as to be coordinated with a used lens system for the reduction pattern printing and, by such selection, it is possible to obtain a necessary deviation magnification (=$\Delta\delta/\Delta\sigma$) required for the detection. Further, since in principle the light intensity distribution upon a detector changes monotonously with the deviation of the second object, to be aligned, it is possible to set a wide detectable range within a limit as determined by the size of the detecting surface 9.

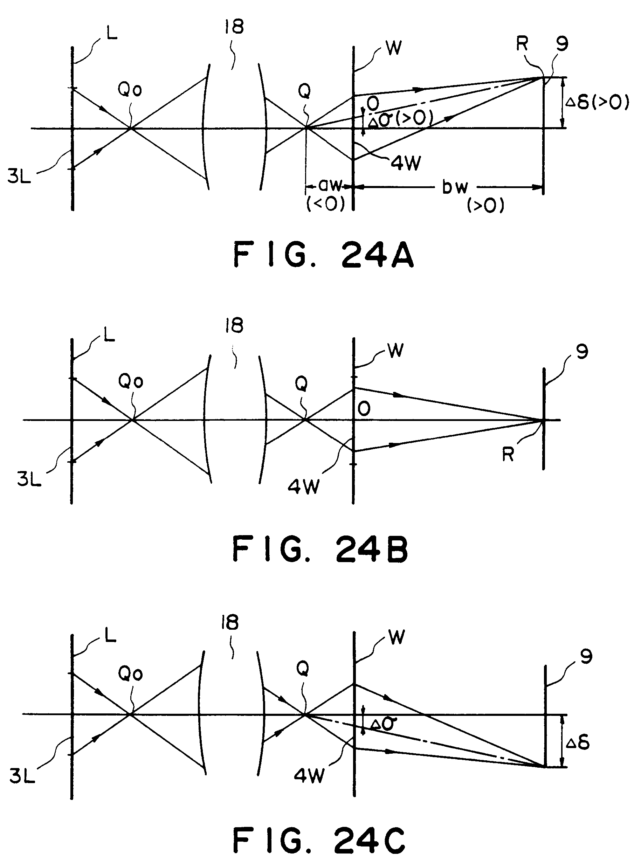

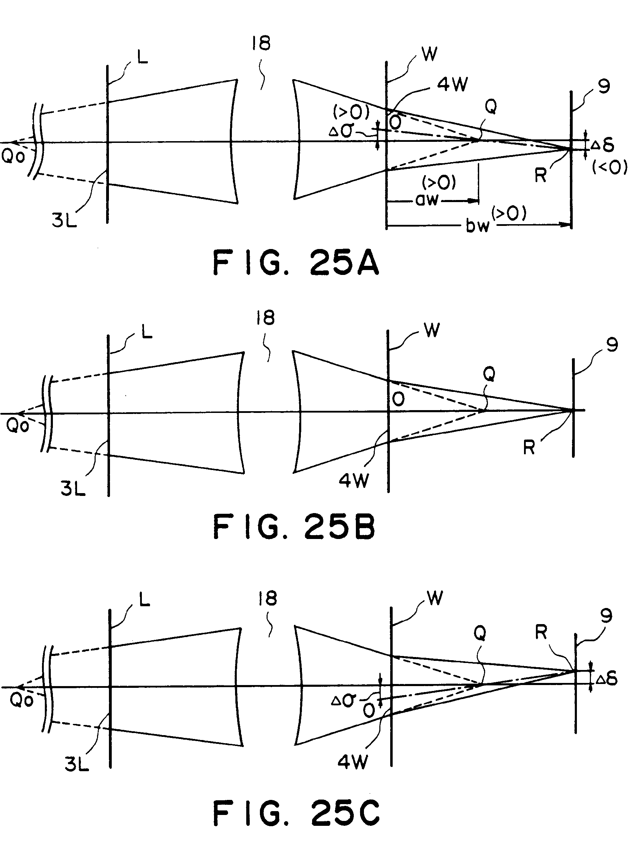

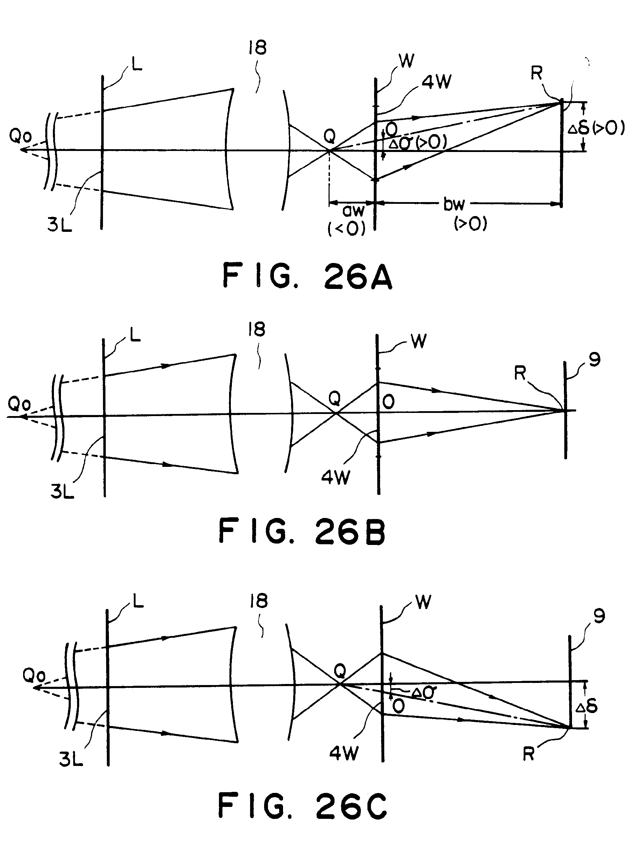

In the example shown in Figures 23A - 23C, the first physical optic element 3L, the lens system 18 and the second physical optic element 4W cooperate to provide a lens system of what can be called a "convex-convex-concave system". However, the invention is not limited to this. For example, an arrangement of what can be called a "convex-convex-convex system" such as shown in Figures 24A - 24C; an arrangement of what can be called a "concave-convex-concave system" such as illustrated in Figures 25A - 25C; and an arrangement of what can be called a "concave-convex-convex system" such as illustrated in Figures 26A - 26C are possible.

In these structure, the relationship between the relative positional deviation $\Delta\sigma$ between the first and second objects with the positional deviation $\Delta\delta$ of the center of gravity of light is, as described hereinbefore, such as follows:

$$\Delta\delta = (1 - bw/aw) \cdot \Delta\sigma$$

The lens structures described just above can be suitably and conveniently selected in accordance with the property of the lens system 18.

Similarly to Figures 23A - 23C, each of Figures 24A, 24C, 25A, 25C, 26A and 26C depicts an occasion where the first and second objects L and W are relatively deviated by a certain amount $\Delta\sigma$, whereas each of Figures 24B, 25B and 26B depicts a state in which the first and second objects L and W are placed in alignment.

In these embodiments, for convenience in explanation, description has been made of examples in which the first physical optic element 3L and the lens system 18 are disposed on the same axis of a coaxial system. However, taking into account that the lens system 18 is a projection lens system for reduction exposure, the optical arrangement may be modified such as illustrated in Figure 27. More specifically, the optical arrangement may be of a what is called "dual-telecentric system" in which, where in the structure shown in Figure 27 a pattern on the reticle L surface is going to be imaged upon the wafer W surface by the lens system 18, chief rays at an arbitrary object point and a corresponding image point, both outside the optical axis, become substantially parallel to the optical axis of the lens system 18.

In the Figure 27 embodiment, the second physical optic element 4W is provided not by a simple concentric type Fresnel zone plate but by an element having a deflecting function. As a result, a half mirror such as one (19) used in the Figure 18 embodiment can be omitted.

In the Figure 27 embodiment, particularly the chief ray on the wafer W side is made perpendicular to the wafer W. As a result, any error caused in setting the wafer in the direction of the optical axis causes, in principle, no shift of a component, in the direction of measurement, of the detecting system. Therefore, such an error does not result in deterioration in the precision.

When the invention is applied to an example where a used lens system 18 is not a dual-telecentric system as shown in Figure 27 or, alternatively, the invention is applied to a case where a used lens system 18 shows aberration with respect to a light used for detection of positional deviation, it is preferable in the point of improved precision that the angle of light emission of the first physical optic element 3L as well as the amount of aberration caused thereby are set such that (i) the chief ray of the light emanating from the lens system 18 and impinging on the second physical optic element 4W becomes perpendicular thereto; and that (ii) the expansion of the object point Q to the second physical optic element 4W due to the aberration is minimized, namely, the light is imaged at point Q with no aberration as a result of the combination of the lens system 18 having a certain aberration with the first physical optic element 3L arranged positively to present a specific aberration that cancels the aberration of the lens system 18.

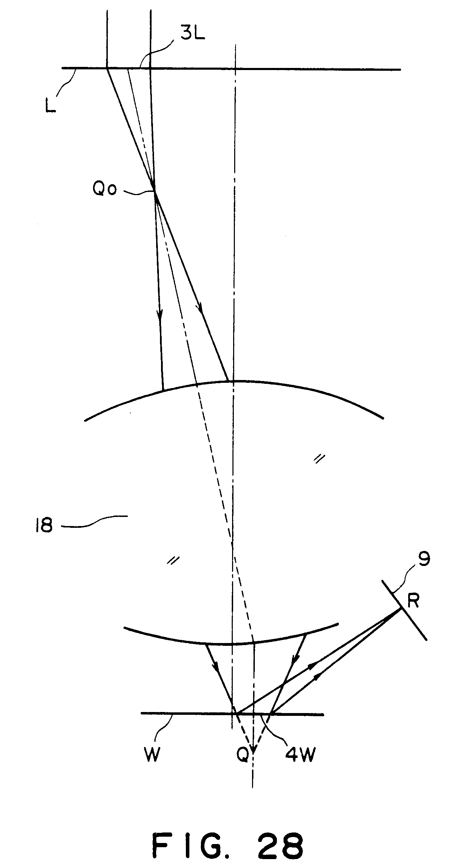

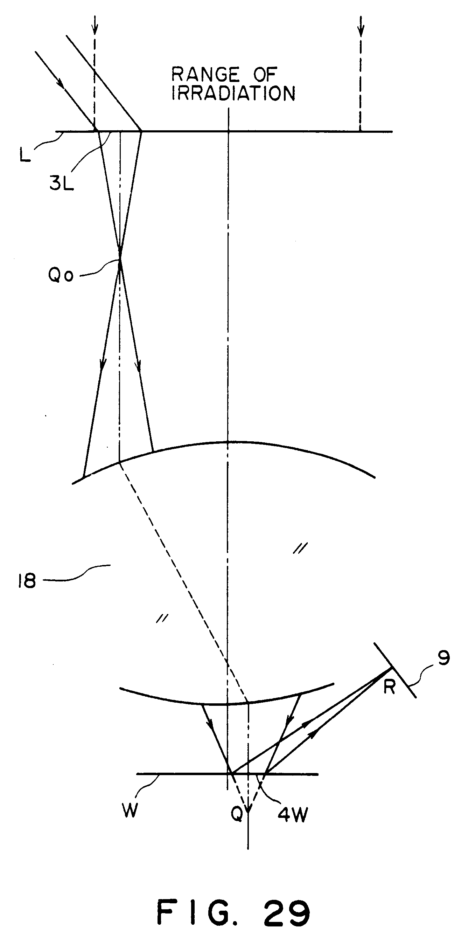

Figure 29 shows another embodiment which is arranged so that a projection optical system of a first alignment pattern provided on a reticle L surface does not interfere with the path of exposure (range of irradiation) for the circuit pattern projection. To accomplish this, the light irradiating the first physical optic element 3L on the reticle L is projected thereupon at an incline as illustrated and, additionally, the first physical optic element 3L is provided by an element having a deflecting component as that used in the Figure 28 embodiment. Thus, the chief ray emanating from the first physical optic element can advance substantially in parallel to an optical axis of the lens system 3. As a result, an arrangement similar to that shown in Figure 27 is attainable.

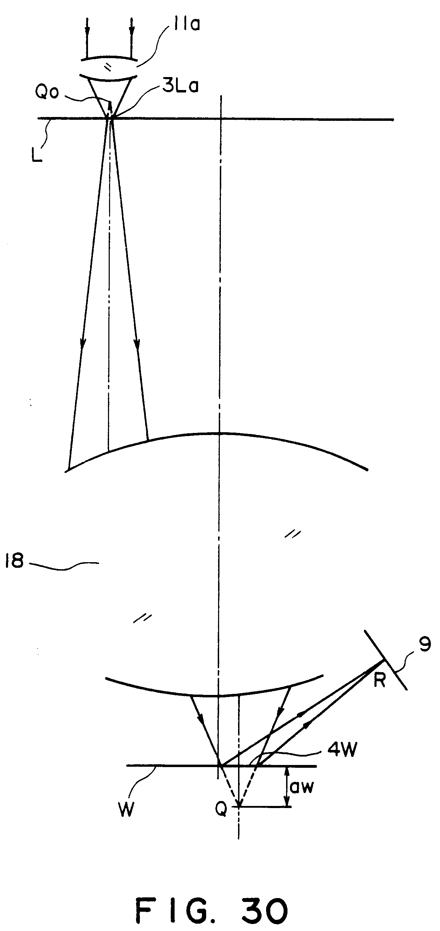

In the embodiments shown in Figures 24A - 24C, 25A - 25C, 26A - 26C, and 27 - 29, a physical optic element such as a Fresnel zone plate is used as an alignment mark 3L provided in a portion of the reticle L surface. However, in another aspect of the present invention, it is possible to utilize on-axis chromatic aberration of a used lens system 18 which may remain in an occasion, for example, where a light used for the alignment and a light used for the exposure (pattern printing) have different wavelengths. For example, as shown in Figure 30, a reticle L may be provided with a minute opening 3La. By projecting light to such opening, light can be focused at a point Q which is outside the wafer W surface. In this example, the minute opening functions as a concave lens for diverging the received light. In this example, a distance denoted at aw in Figure 30 corresponds to the on-axis chromatic aberration. In this example, where the reduction lens system is such a lens system (called a "spheroachromat type") whose spherical aberration has been corrected both for the wavelength used for the pattern printing and for the wavelength used for the alignment, it is possible to obtain an aberration-free imaging point whose diameter (spot size) is substantially determined by the numerical aperture of the lens system 18 and whose position is determined by the position of the edge of the minute opening on the reticle L surface. The minute opening may be provided by patterning of the reticle or by forming a through-bore in the reticle.

If, as an example, the wavelength $\lambda$ of the light used for the alignment is 0.83 micron; the numerical aperture (NA) of the lens system on the side facing the wafer is 0.5; and the imaging magnification is -1/5; then the size of the point image formed by the minute opening on the reticle surface is about 2 microns, in accordance with "$1.22\lambda$/NA" (Rayleigh's equation).

Therefore, by providing on the reticle L an aperture 3La of a size of about 1 - 5 microns, the minimum spot diameter as restricted by the expansion of the aperture can be reduced by the magnification of the lens system and, thus, it can be disregarded. As a result, the size of the spot Q can be made small to an order of about 2 microns. Also, the position of the point Q is defined at such position as determined by the imaging magnification of the lens system 18 which is determined in relation to the wavelength used for the alignment. As a result, similarly to the foregoing examples, the optical arrangement is such that the point Q is an object point which is re-imaged upon the detector 9 by means of the second physical optic element 4W on the wafer W surface.

Denoted at 11a in Figure 30 is an illumination system which may be disposed, as required, for effectively projecting light upon the minute opening.

In these embodiments, provided that the angle of incidence of the projected light is determined and that the projected light has a substantially uniform illuminance distribution, basically the position of the point $Q_0$ (and thus the position of the point Q) is determined by the design specification of the first physical optic element, and it is not affected by a slight distribution change of the projected light. This is advantageous.

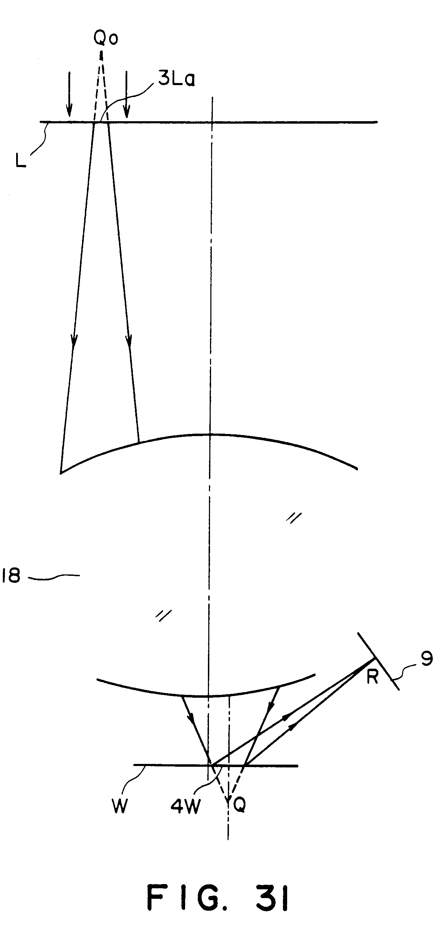

In an occasion where the alignment mark region of the first object surface can be constantly irradiated with a light of uniform illuminance distribution, it is possible to use, as alignment mark of the first object, such an aperture as having a slight expansion, as shown in Figure 31. More specifically, similarly to the "concave-convex-concave system" or the "concave-convex-concave system" as illustrated in Figures 25A - 25C and Figures 26A - 26C, it is possible to define a light flux, with respect to a light flux diffracted by the edge of the aperture 3La, as if the point $Q_0$, which can be considered as an intersection of asymptote, exists. As a result, it is possible to form the point Q in a similar manner as in the foregoing examples and, for this reason, it is possible to form a point image R upon the detector 6 surface.

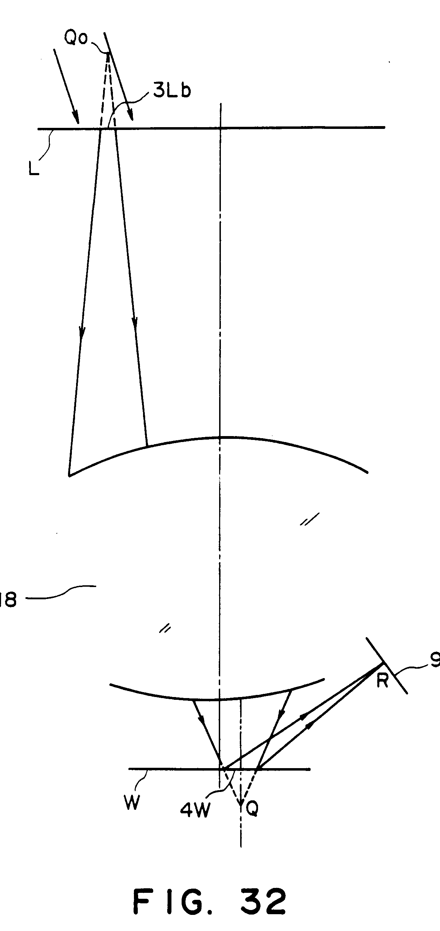

As a further alternative, as illustrated in Figure 32, a diffraction grating having a light deflecting function may be used as a first alignment mark 3Lb on the first object L surface.

More specifically, in Figure 32, reference character 3Lb denotes a diffraction grating formed by rectilinear patterns of regular intervals extending in a direction perpendicular to the sheet of the drawing. As illustrated, it functions to diffract a light, incident at an incline with respect to the optical axis of the lens system 18, in a direction parallel to the optical axis. In this example, the size of the diffraction grating 3Lb is sufficiently small, and it can function as a concave lens diverging a received light, similarly to the minute opening shown in Figure 30. The remaining portion of this embodiment is substantially the same as the Figure 30 embodiment.

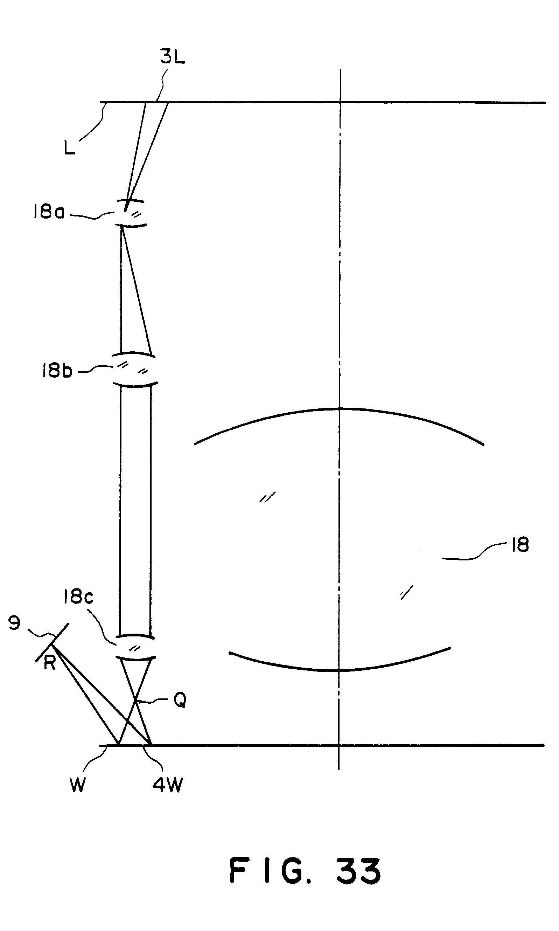

In the embodiments shown in Figures 24A - 32, description has been made of an alignment system of what can be called a "TTL type" in which a pattern printing reduction projection lens system 18 is used as a condensing optical system 18. However, as exemplified in Figure 33, separate lens portions 18a, 18b and 18c which can be considered as a unit with the lens system 18 (namely, no relative displacement of them to the lens system 18 occurs) may be used as a condensing optical system.

In the Figure 33 embodiment, the light from an alignment pattern 3L of a reticle L is directed by way of these lens portions 18a, 18b and 18c to a second alignment pattern 4W on a wafer W.

By using the lens group 18a - 18c which can be considered as a unit with the lens system 18, an image point Q of the point $Q_0$ is formed outside the wafer W, which point image is re-imaged by the second physical optic element 4W, with a result of similar advantageous effects.

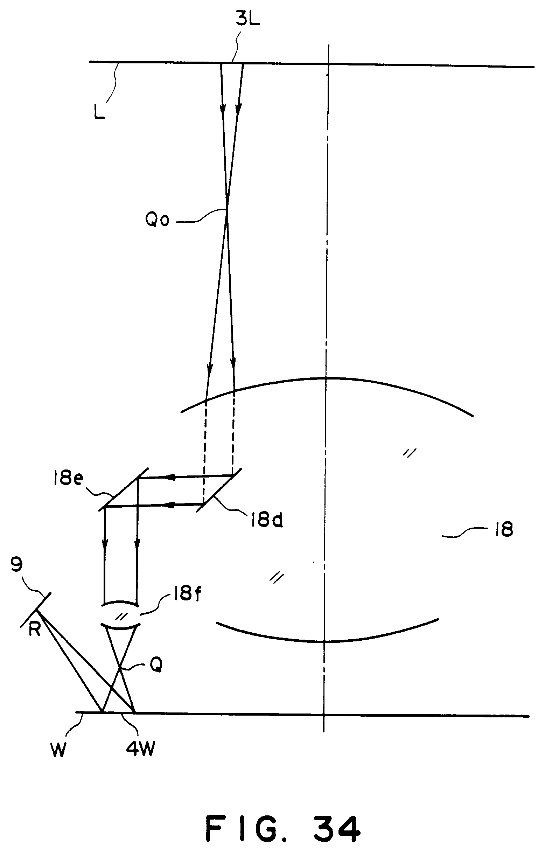

Further, as shown in Figure 34, the optical arrangement may be modified so that a light from a first alignment pattern 3L of a reticle L first passes through a portion of a lens system 18 for the pattern printing and, subsequently, it is directed to a second alignment pattern 4W on a wafer W by way of separate optical components such as denoted at 18d, 18e and 18f.

While the invention has been described with reference to the structures disclosed herein, it is not confined to the details set forth and this application is intended to cover such modifications or changes as may come within the scope of the following claims.

## Claims

1. A method of detecting the relative positional deviation between first (1; M; L) and second (2; W) objects in a predetermined direction perpendicular to the direction in which the first and second objects are opposed to each other, comprising the steps of:

   providing the first object with a first optical element (3a; 3b; 3c; 3M; 3M1; 3L; 3La) for converging or diverging an incident radiation beam;

   providing the second object with a second optical element (4a; 4b; 4c; 4W; 4W1) for converging or diverging an incident radiation beam, said first and second optical elements being effective together to provide positive magnification;

   projecting a radiation beam (5) onto said first optical element in such a manner that the radiation beam (6; 6a) converged or diverged by said first optical element impinges on said second optical element and is converged onto a photoelectric sensor (8), whereupon any relative positional deviation ($\Delta\sigma$) between the first and second objects causes deflection of the beam;

   detecting the position of incidence ($\Delta\delta$) of said radiation beam on said photoelectric sensor (8); and processing an electric signal from the sensor (8) with respect to a reference signal to detect the relative positional deviation between the first and second objects in the predetermined direction.

2. A method as claimed in claim 1, further comprising the step of aligning the first and second objects on the basis of the detected deviation.

3. A method as claimed in claim 1, wherein at least one of the first and second optical elements comprises a Fresnel zone plate.

4. A method as claimed in claim 1, wherein at least one of the first and second optical elements comprises a mirror having a concave mirror surface.

5. A method as claimed in claim 1, wherein the radiation beam is converged by the first optical element at a point (Q; Qo) which is then imaged by the second optical element upon the light receiving surface (9) of the photoelectric sensor or a plane optically conjugate with the same.

6. An exposure system for projecting a pattern on a mask (M; L) on to a wafer (W) by a radiation beam from a radiation source (10) in order to transfer the pattern of the mask on to the wafer, comprising means (22, 21) to align the mask and the wafer in accordance with a detected positional deviation between them, and further comprising:

   a) a first optical element (3M; 3M1; 3L; 3La) provided on the mask for converging or diverging an incident radiation beam from the radiation source;

   b) a second optical element (4W; 4W1) provided on the wafer for converging or diverging an incident radiation beam from the first optical element, said first and second optical elements being effective together to provide positive magnification; whereupon any relative positional deviation ($\Delta\sigma$) between the mask and the wafer causes deflection of the beam;

   c) a photoelectric sensor (8) to detect thereon the position of incidence of the radiation beam from the second optical element; and

   d) a signal processor (23) connected to the sensor to process an electric signal indicative of the relative

positional deviation ($\Delta\sigma$) between the mask and the wafer in a direction normal to the direction in which the mask and the wafer are opposed to one another, in relation to a reference signal to determine the deviation.

7. A system as claimed in claim 6, further comprising transferring means contributable to transfer, through exposure with radiation, the pattern of the mask to the wafer while the mask and the wafer are held in proximity to each other.

8. A system as claimed in claim 7, wherein said transferring means includes a projection optical system (18; 25, 26; 25a, 26b, 27) through which the pattern of the mask is projected and transferred to the wafer.

9. A system as claimed in claim 6, 7 or 8, wherein said first optical element (3a) is converging and the second optical element is converging (4a).

10. A system as claimed in claim 6, 7 or 8, wherein said first optical element (3b) is diverging and said second optical element (4b) is converging.

11. A system as claimed in claim 6, 7 or 8, wherein said first optical element (3c) is converging and said second optical element (4c) is diverging.

12. A semiconductor device manufacturing method in which a pattern on a mask (M; L) is projected on to a wafer (W) by a radiation beam from a radiation source (10) in order to transfer the pattern of the mask on to the wafer, means (21, 22) being provided to align the mask and the wafer in accordance with a detected deviation between them, comprising the steps of:
a) providing the mask with a first optical element (M; 3M1; 3L; 3La) for converging or diverging an incident radiation beam from the radiation source;
b) providing the wafer with a second optical element (4W; 4W1) for converging or diverging an incident radiation beam from the first optical element, said first and second optical elements being effective together to provide positive magnification;
c) providing a photoelectric sensor (8) to detect the radiation beam from the second optical element; and
d) providing a signal processor (23) connected to the sensor to process an electrical signal indicative of the relative positional deviation ($\Delta\sigma$) between the mask and the wafer in a direction normal to the direction in which the mask and the wafer are opposed to one another, with respect to a reference signal, to determine the deviation ($\Delta\sigma$).

13. A method as claimed in any one of claims 1 to 5 and 12, wherein said first optical element (3a) is converging and the second optical element is converging (4a).

14. A method as claimed in any one of claims 1 to 5 and 12, wherein said first optical element (3b) is diverging and said second optical element (4b) is converging.

15. A method as claimed in any one of claims 1 to 5 and 12, wherein said first optical element (3c) is converging and said second optical element (4c) is diverging.

**Patentansprüche**

1. Verfahren zur Erfassung der relativen Positionsabweichung zwischen ersten (1; M; L) und zweiten (2; W) Gegenständen in einer vorbestimmten Richtung senkrecht zu der Richtung, in der sich die ersten und zweiten Gegenstände einander gegenüberstehen mit folgenden Schritten:
Versehen des ersten Gegenstandes mit einem ersten optischen Element (3a; 3b; 3c; 3M; 3M1; 3L; 3La) zum Konvergieren oder Divergieren eines einfallenden Strahlenbündels;
Versehen des zweiten Gegenstandes mit einem zweiten optischen Element (4a; 4b; 4c; 4W; 4W1) zum Konvergieren oder Divergieren eines einfallenden Strahlenbündels, wobei die ersten und zweiten optischen Elemente zusammenwirken, um eine positive Vergrößerung zu schaffen;
Projizieren eines Strahlenbündels (5) auf das erste optische Element in einer solchen Weise, daß das durch das erste optische Element konvergierte oder divergierte Strahlenbündel auf das zweite optische Element trifft und auf einen photoelektrischen Sensor (8) konvergiert wird, woraufhin jede relative

Positionsabweichung ($\Delta\sigma$) zwischen den ersten und zweiten Gegenständen eine Ablenkung des Strahl verursacht;

Erfassen der Einfallsposition ($\Delta\sigma$) des Strahlenbündels auf den photoelektrischen Sensor (8); und Verarbeiten eines elektrischen Signales aus dem Sensor (8) bezüglich eines Referenzsignales zur Erfassung der relativen Positionsabweichung zwischen den ersten und zweiten Gegenständen in der vorbestimmten Richtung.

2. Verfahren nach Anspruch 1, weiterhin mit dem Schritt des Ausrichtens der ersten und zweiten Gegenstände auf der Basis der erfaßten Abweichung.

3. Verfahren nach Anspruch 1, wobei wenigstens eines der ersten und zweiten optischen Elemente eine Fresnelzonenplatte aufweist.

4. Verfahren nach Anspruch 1, wobei wenigstens eines der ersten und zweiten optischen Elemente einen Spiegel aufweist mit einer konkaven Spiegeloberfläche.

5. Verfahren nach Anspruch 1, wobei das Strahlenbündel durch das erste optische Element an einem Punkt (Q; Qo) konvergiert wird, welcher dann durch das zweite optische Element auf die Lichtaufnahmefläche (9) des photoelektrischen Sensors oder eine mit diesem optisch konjugierte Ebene abgebildet wird.

6. Belichtungssystem zur Projektion eines Musters auf einer Maske (M; L) auf einen Wafer (W) durch ein Strahlenbündel aus einer Strahlenquelle (10) zur Übertragung des Musters auf der Maske auf den Wafer mit einer Einrichtung (22, 21) zur Ausrichtung der Maske und des Wafers in Übereinstimmung mit einer erfaßten Positionsabweichung zwischen ihnen, weiterhin mit:

a) einem ersten optischen Element (3M; 3M1; 3L; 3La), welches auf der Maske zum Konvergieren oder Divergieren eines einfallenden Strahlenbündels aus der Strahlenquelle vorgesehen ist;

b) einem zweiten optischen Element (4W; 4W1), welches auf dem Wafer zum Konvergieren oder Divergieren eines einfallenden Strahlenbündels aus dem ersten optischen Element vorgesehen ist, wobei die ersten und zweiten optischen Elemente zusammenwirken, um eine-positive Vergrößerung zu schaffen; woraufhin jede Positionsabweichung ($\Delta\sigma$) zwischen der Maske und des Wafers eine Ablenkung des Strahles verursacht;

c) einem photoelektrischen Sensor (8) zur Erfassung der Einfallposition des Strahlenbündels aus dem zweiten optischen Element; und

d) einem mit dem Sensor verbundenen Signalprozessor zur Verarbeitung eines elektrischen Signales, welches die relative Positionsabweichung ($\Delta\sigma$) zwischen der Maske und dem Wafer in einer Richtung normal zu der Richtung anzeigt, in der sich die Maske und der Wafer einander gegenüberstehen, in Relation zu einem Referenzsignal, um die Abweichung zu bestimmen.

7. System nach Anspruch 6, weiterhin mit einer Übertragungseinrichtung zur Übertragung, durch Bestrahlungsbelichtung, des Musters der Maske auf den Wafer, während die Maske und der Wafer nahe beieinander gehalten sind.

8. System nach Anspruch 7, wobei die Übertragungseinrichtung ein optisches Projektionssystem (18; 25, 26; 25a, 26b, 27) aufweist, durch das das Muster der Maske projiziert und auf den Wafer übertragen wird.

9. System nach Anspruch 6, 7 oder 8, wobei das erste optische Element (3a) konvergiert und das zweite optische Element (4a) konvergiert.

10. System nach Anspruch 6, 7 oder 8, wobei das erste optische Element (3b) divergiert und das zweite optische Element (4b) konvergiert.

11. System nach Anspruch 6, 7 oder 8, wobei das erste optische Element (3c) konvergiert und das zweite optische Element (4c) divergiert.

12. Herstellungsverfahren für eine Halbleitervorrichtung, bei dem ein Muster auf einer Maske (M; L) auf einen Wafer (W) durch ein Strahlenbündel aus einer Strahlenquelle (10) zur Übertragung des Musters der Maske auf den Wafer projiziert wird, eine Einrichtung (21, 22) vorgesehen ist zur Ausrichtung der Maske und des Wafers entsprechen einer erfaßten Abweichung zwischen ihnen, mit folgenden Schritten:

a) Versehen der Maske mit einem ersten optischen Element (3M; 3M1; 3L; 3La), zum Konvergieren

23

oder Divergieren eines einfallenden Strahlenbündels aus der Strahlenquelle;

b) Versehen der Maske mit einem zweiten optischen Element (4W; 4W1), zum Konvergieren oder Divergieren eines einfallenden Strahlenbündels aus dem ersten optischen Element, wobei die ersten und zweiten optischen Elemente zusammenwirken, um eine positive Vergrößerung zu schaffen;

c) Vorsehen eines photoelektrischen Sensor (8) zur Erfassung des Strahlenbündels aus dem zweiten optischen Element; und

d) Vorsehen eines mit dem Sensor verbundenen Signalprozessor zur Verarbeitung eines elektrischen Signales, welches die relative Positionsabweichung (Δσ) zwischen der Maske und dem Wafer in einer Richtung normal zu der Richtung anzeigt, in der sich die Maske und der Wafer einander gegenüberstehen, in Relation zu einem Referenzsignal, um die Abweichung (Δσ) zu bestimmen.

13. Verfahren nach einem der Ansprüche 1 bis 5 und 12, wobei das erste optische Element (3a) konvergiert und das zweite optische Element (4a) konvergiert.

14. Verfahren nach einem der Ansprüche 1 bis 5 und 12, wobei das erste optische Element (3b) divergiert und das zweite optische Element (4b) konvergiert.

15. Verfahren nach einem der Ansprüche 1 bis 5 und 12, wobei das erste optische Element (3c) konvergiert und das zweite optische Element (4c) divergiert.

**Revendications**

1. Procédé de détection d'écart des positions relatives de premier (1 ; M ; L) et second (2 ; W) objets dans une direction prédéterminée perpendiculaire à la direction dans laquelle les premier et second objets sont opposés l'un à l'autre, comprenant les étapes dans lesquelles :

on pourvoit le premier objet d'un premier élément optique (3a ; 3b ; 3c ; 3M ; 3M1 ; 3L ; 3La) destiné à faire converger ou diverger un faisceau de rayonnement incident ;

on pourvoit le second objet d'un second élément optique (4a ; 4b ; 4c ; 4W ; 4W1) destiné à faire converger ou diverger un faisceau de rayonnement incident, lesdits premier et second éléments optiques ayant pour effet de produire, ensemble, un grossissement positif ;

on projette un faisceau de rayonnement (5) sur ledit premier élément optique de manière que le faisceau de rayonnement (6 ; 6a) que ledit premier élément optique fait converger ou diverger tombe sur ledit second élément optique, lequel le fait converger sur un capteur photo-électrique (8), à la suite de quoi tout écart (Δσ) des positions relatives des premier et second objets provoque une déflexion du faisceau ;

on détecte la position d'incidence (Δδ) dudit faisceau de rayonnement sur ledit capteur photo-électrique (8) ; et

on traite un signal électrique provenant du capteur (8) par rapport à un signal de référence pour détecter l'écart des positions relatives des premier et second objets dans la direction prédéterminée.

2. Procédé selon la revendication 1, comprenant en outre l'étape d'alignement des premier et second objets sur la base de l'écart détecté.

3. Procédé selon la revendication 1, dans lequel au moins l'un des premier et second éléments optiques comprend une plaque à zones de Fresnel.

4. Procédé selon la revendication 1, dans lequel au moins l'un des premier et second éléments optiques comprend un miroir ayant une surface de miroir concave.

5. Procédé selon la revendication 1, dans lequel le premier élément optique fait converger le faisceau de rayonnement en un point (Q ; Qo) dont une image est ensuite formée par le second élément optique sur la surface (9) de réception de lumière du capteur photo-électrique ou d'un plan qui en est un conjugué optique.

6. Système d'exposition pour projeter un motif, porté par un masque (M ; L), sur une tranche (W) au moyen d'un faisceau de rayonnement provenant d'une source (10) de rayonnement afin de reporter le motif du masque sur la tranche, comportant des moyens (22, 21) destinés à aligner le masque et la tranche conformément à un écart détecté de positions entre eux, et comportant en outre :

a) un premier élément optique (3M ; 3M1 ; 3L ; 3La) situé sur le masque pour converger ou diverger un faisceau de rayonnement incident provenant de la source de rayonnement ;

b) un second élément optique (4W ; 4W1) situé sur la tranche pour faire converger et diverger un faisceau de rayonnement incident provenant du premier élément optique, lesdits premier et second éléments optiques ayant pour effet de produire ensemble un grossissement positif ; à la suite de quoi tout écart ($\Delta\sigma$) des positions relatives du masque et de la tranche provoque une déflexion du faisceau ;

c) un capteur photo-électrique (8) destiné à détecter la position d'incidence du faisceau de rayonnement qu'il reçoit du second élément photo-électrique ; et

d) un processeur (23) de signal connecté au capteur pour traiter un signal électrique représentatif de l'écart ($\Delta\sigma$) des positions relatives du masque et de la tranche dans une direction normale à la direction dans laquelle le masque et la tranche sont opposés l'un à l'autre, par rapport à un signal de référence pour déterminer l'écart.

7. Système selon la revendication 6, comportant en outre des moyens de report pouvant contribuer au report, par exposition à un rayonnement, du motif du masque sur la tranche, tandis que le masque et la tranche sont maintenus à proximité l'un de l'autre.

8. Système selon la revendication 7, dans lequel lesdits moyens de report comprennent un système optique de projection (18 ; 25, 26 ; 25a, 26b, 27) à travers lequel le motif du masque est projeté et reporté sur la tranche.

9. Système selon la revendication 6, 7 ou 8, dans lequel ledit premier élément optique (3a) est convergent et le second élément optique (4a) est convergent.

10. Système selon la revendication 6, 7 ou 8, dans lequel ledit premier élément optique (3b) est divergent et ledit second élément optique (4b) est convergent.

11. Système selon la revendication 6, 7 ou 8, dans lequel ledit premier élément optique (3c) est convergent et ledit second élément optique (4c) est divergent.

12. Procédé de fabrication de dispositifs à semiconducteurs dans lequel un motif situé sur un masque (M ; L) est projeté sur une tranche (W) par un faisceau de rayonnement provenant d'une source (10) de rayonnement afin que le motif du masque soit reporté sur la tranche, des moyens (21, 22) étant prévus pour aligner le masque et la tranche conformément à un écart détecté entre eux, comprenant les étapes dans lesquelles :

a) on pourvoit le masque d'un premier élément optique (3M ; 3M1 ; 3L ; 3La) destiné à faire converger ou diverger un faisceau de rayonnement incident provenant de la source de rayonnement ;

b) on pourvoit la tranche d'un second élément optique (4W ; 4W1) destiné à faire converger ou diverger un faisceau de rayonnement incident provenant du premier élément optique, lesdits premier et second éléments optiques ayant pour effet de produire ensemble un grossissement positif ;

c) on utilise un capteur photo-électrique (8) pour détecter le faisceau de rayonnement provenant du second élément optique ; et

d) on utilise un processeur (23) de signal connecté au capteur pour traiter un signal électrique représentatif de l'écart ($\Delta\sigma$) des positions relatives du masque et de la tranche dans une direction normale à la direction dans laquelle le masque et la tranche sont opposés l'un à l'autre, par rapport à un signal de référence, pour déterminer l'écart ($\Delta\sigma$).

13. Procédé selon l'une quelconque des revendications 1 à 5 et 12, dans lequel ledit premier élément optique (3a) est convergent et le second élément optique (4a) est convergent.

14. Procédé selon l'une quelconque des revendications 1 à 5 et 12, dans lequel ledit premier élément optique (3b) est divergent et ledit second élément optique (4b) est convergent.

15. Procédé selon l'une quelconque des revendications 1 à 5 et 12, dans lequel ledit premier élément optique (3c) est convergent et ledit second élément optique (4c) est divergent.

F I G. I

F I G. 2

F I G. 3

F I G. 4

F I G. 5

F I G. 6A

F I G. 6B

30

F I G. 7A

F I G. 7B

F I G. 8A. I

F I G. 8A. 2

F I G. 8B. I

F I G. 8B. 2

F I G. 8C

F I G. 8D

F I G. 8E

P₁  P₂

REFRACTIVE
INDEX n₀

REFRACTIVE
INDEX n    d₁    d₂

# F I G. 8F

P₁  P₂

REFRACTIVE
INDEX n₀

d

# F I G. 8G

F I G. 8H

F I G. 8I

# F I G. 9

# F I G. 10

FIG. IIA

START

MOVE WAFER STAGE 21
TO BRING REF. MARK 25
TO EVALUATION STATION

SET MASK POSITION BY
USING SIG. FROM
DETECTOR 24

MOVE WAFER STAGE 21
TO BRING WAFER
ALIGNMENT PATTERN TO
EVALUATION STATION

CALCULATE POSITIONAL
ERROR OF WAFER FROM
REF. POSITION BY USING
SIG. FROM DETECTOR 24

MOVE WAFER STAGE
21 TO CORRECT
POSITIONAL ERROR

|ERROR| $\leqq$ TOLERANCE ?   NO

YES

END

F I G. IIB

F I G. 12

F I G. 13

# F I G. 14

# F I G. 15

F I G. 16

EP 0 333 326 B1

```
            ┌─────────────┐
            │   START     │
            └──────┬──────┘
                   │
                   ▼
      ┌──────────────────────────┐
      │ MOVE WAFER STAGE 21      │
      │ TO BRING REF. MARK 25    │
      │ TO EVALUATION STATION    │
      └────────────┬─────────────┘
                   │
                   ▼
      ┌──────────────────────────┐
      │ SET MASK POSITION BY     │
      │ USING SIG. FROM          │
      │ DETECTOR 24              │
      └────────────┬─────────────┘
                   │
                   ▼
      ┌──────────────────────────┐
      │ MOVE WAFER STAGE 21      │
      │ TO BRING WAFER           │
      │ ALIGNMENT PATTERN TO     │
      │ EVALUATION STATION       │
      └────────────┬─────────────┘
                   │◄──────────────────────────────┐
                   ▼                                │
   ┌──────────────────────────┐    ┌──────────────────────────┐
   │ CALCULATE POSITIONAL     │    │ MOVE WAFER STAGE         │
   │ ERROR OF WAFER FROM      │    │ 21 TO CORRECT            │
   │ REF. POSITION BY USING   │    │ POSITIONAL ERROR         │
   │ SIG. FROM DETECTOR 24    │    └────────────▲─────────────┘
   └────────────┬─────────────┘                 │
                ▼                                │
         ◇───────────────────◇       NO         │
        ⟨ IERRORI ≦TOLERANCE ? ⟩──────────────────┘
         ◇───────────────────◇
                │ YES
                ▼
         ┌─────────────┐
         │   E N D     │
         └─────────────┘
```

# F I G. 17

# F I G. 18

F I G. 19

F I G. 20

F I G. 21

# F I G. 22

F I G. 23A

F I G. 23B

F I G. 23C

FIG. 24A

FIG. 24B

FIG. 24C

F I G. 25A

F I G. 25B

F I G. 25C

FIG. 26A

FIG. 26B

FIG. 26C

FIG. 27

# FIG. 28

RANGE OF
IRRADIATION

L

3L

Qo

18

//

//

9

R

W

Q

4W

# FIG. 29

F I G. 30

# F I G. 31

# FIG. 32

# F I G. 33

# F I G. 34